# EUROPEAN PATENT APPLICATION

(11) **EP 4 760 280 A1**
(43) Date of publication of application: **17.06.2026**
(21) Application number: 25192347.0
(22) Date of filing: 29.07.2025
(51) Int. Cl.: G01R 31/01

(54) **CAPACITOR DEFECT MONITORING DEVICE, METHOD OF MONITORING CAPACITOR DEFECT USING THE DEVICE AND STORAGE DEVICE USING THE DEVICE**

(30) Priority: 12.12.2024 KR 20240184922; 30.06.2025 US 202519254574
(71) Applicant: Samsung Electronics Co., Ltd., Suwon-si, Gyeonggi-do 16677 (KR)
(72) Inventor: MIN, Kwanil, 16677 Suwon-si, Gyeonggi-do (KR); CHUN, Ho-Jin, 16677 Suwon-si, Gyeonggi-do (KR); JEONG, Jong-Wook, 16677 Suwon-si, Gyeonggi-do (KR)
(74) Representative: Kuhnen & Wacker Patent- und Rechtsanwaltsbüro PartG mbB

(57) **Abstract**

Disclosed is a capacitor defect monitoring device which includes a power integrated circuit that outputs one of a primary power and an auxiliary power, and an auxiliary power storage circuit configured to provide the auxiliary power and comprising one or more storage capacitors. The power integrated circuit includes a selection circuit that selects one of the primary power and the auxiliary power, a connection circuit that provides a connection path between the selection circuit and the auxiliary power storage circuit, and a defect type determination circuit. The power integrated circuit includes a defect type determination circuit configured to monitor changes in voltage values of the one or more storage capacitors to determine a defect type of the auxiliary power storage circuit based on changing a resistance value of the connection path..

## Description

### CROSS-REFERENCE TO RELATED APPLICATIONS

This application claims priority under 35 U.S.C. § 119 to Korean Patent Application No. 10-2024-0184922 filed on December 12, 2024, in the Korean Intellectual Property Office, the disclosures of which are incorporated by reference herein in their entireties.

### BACKGROUND

Embodiments of the present disclosure relate to a semiconductor device, and more particularly, relate to a capacitor defect monitoring device, a capacitor defect monitoring method using the capacitor defect monitoring device, and a storage device using the capacitor defect monitoring device.

An active integrated circuit or peripheral circuits of the active integrated circuit may include capacitors having various purposes. For example, the capacitors may include various types of capacitors such as a ceramic capacitor, an electrolytic capacitor, and a film capacitor. For example, in a power supply circuit, a rectifier circuit, a filter circuit, an oscillation circuit, etc., the capacitors may be used for energy storage, filtering, voltage stabilization, coupling, time delay, oscillation, etc.

The performance of the capacitors may be reduced over time due to aging, degradation, overvoltage, physical vibration, moisture, etc.

### SUMMARY

Embodiments of the present disclosure provide a capacitor defect monitoring device efficiently detecting various defect types of capacitors of an active integrated circuit.

Embodiments of the present disclosure provide a capacitor defect monitoring method using the device.

Embodiments of the present disclosure provide a storage device using the device.

According to an embodiment, a capacitor defect monitoring device includes a power integrated circuit that outputs one of a primary power and an auxiliary power, and an auxiliary power storage circuit configured to provide the auxiliary power and comprising one or more storage capacitors. The power integrated circuit includes a selection circuit that selects one of the primary power and the auxiliary power, a connection circuit that provides a connection path between the selection circuit and the auxiliary power storage circuit, and a defect type determination circuit. The power integrated circuit includes a defect type determination circuit configured to monitor changes in voltage values of the one or more storage capacitors to determine a defect type of the auxiliary power storage circuit based on changing a resistance value of the connection path.

According to an embodiment, a method of monitoring a capacitor defect includes outputting, by a power integrated circuit, an auxiliary power, wherein the power integrated circuit is configured to output one of a primary power and the auxiliary power, wherein the auxiliary power is provided using an auxiliary power storage circuit, and wherein the primary power is provided from an external source, the power integrated circuit comprising a selection circuit and a connection circuit, the selection circuit selecting one of the primary power and the auxiliary power, and the connection circuit providing a connection path between the selection circuit and the auxiliary power storage circuit; changing a resistance value of the connection path in an auxiliary power monitoring mode; monitoring changes in voltage values of one or more storage capacitors of the auxiliary power storage circuit based on changing the resistance value of the connection path; and determining a defect type of the auxiliary power storage circuit based on the monitoring.

According to an embodiment, a storage device includes a power loss protection integrated circuit (PLP IC) that outputs one of a primary power and an auxiliary power, and an auxiliary power storage circuit configured to provide the auxiliary power and comprising one or more storage capacitors. The PLP IC includes a selection circuit that selects one of the primary power and the auxiliary power, a connection circuit that provides a connection path between the selection circuit and the auxiliary power storage circuit, and a defect type determination circuit configured to monitor changes in voltage values of the one or more storage capacitors to determine a defect type of the auxiliary power storage circuit based on changing a resistance value of the connection path.

### BRIEF DESCRIPTION OF DRAWINGS

The above and other objects and features of the present disclosure will become apparent by describing in detail embodiments thereof with reference to the accompanying drawings.
FIG. 1 is a block diagram illustrating a capacitor defect monitoring device according to an embodiment of the present disclosure.
FIG. 2 is a block diagram illustrating an embodiment of a selection circuit of FIG. 1.
FIG. 3 is a diagram illustrating voltage levels of capacitors of an auxiliary power storage circuit when the auxiliary power storage circuit is charged or discharged.
FIG. 4 is a diagram for describing a defect type of an auxiliary power storage circuit according to an embodiment of the present disclosure.
FIGS. 5A, 5B, and 5C are diagrams for illustrating a short-circuit defect and an equivalent series resistance (ESR) defect according to an embodiment of the present disclosure.
FIG. 6 is a flowchart illustrating a capacitor defect monitoring method according to an embodiment of the present disclosure.
FIG. 7 is a block diagram illustrating a defect type determination circuit according to an embodiment of the present disclosure.
FIG. 8 is a block diagram illustrating a connection circuit according to an embodiment of the present disclosure.
FIG. 9 is a graph indicating a change in a voltage level when a defect type of an auxiliary power storage circuit is a first type according to an embodiment of the present disclosure.
FIGS. 10A, 10B, and 10C are graphs indicating a change in a voltage level when a defect type of an auxiliary power storage circuit is a second type according to an embodiment of the present disclosure.
FIG. 11 is a block diagram illustrating a capacitor defect monitoring device according to an embodiment of the present disclosure.
FIG. 12 is a flowchart illustrating an operation of a capacitor defect monitoring device according to an embodiment of the present disclosure.
FIG. 13 is a flowchart illustrating an operation of a capacitor defect monitoring device according to an embodiment of the present disclosure.
FIG. 14 is a flowchart illustrating an operation of a capacitor defect monitoring device of according to an embodiment of the present disclosure.
FIG. 15 is a flowchart illustrating an operation of a capacitor defect monitoring device of according to an embodiment of the present disclosure.
FIG. 16 is a flowchart illustrating an operation of a capacitor defect monitoring device of according to an embodiment of the present disclosure.
FIG. 17 is a flowchart illustrating an operation of a capacitor defect monitoring device of according to an embodiment of the present disclosure.
FIG. 18 is a block diagram illustrating an embodiment of a defect type determination circuit according to an embodiment of the present disclosure.
FIG. 19 is a block diagram illustrating an electronic system including a capacitor defect monitoring device according to an embodiment of the present disclosure.
FIG. 20 is a flowchart illustrating an operation of an electronic system according to an embodiment of the present disclosure.
FIG. 21 is a block diagram illustrating a data center including a capacitor defect monitoring device according to embodiments of the present disclosure.

### DETAILED DESCRIPTION

Below, embodiments of the present disclosure will be described in detail and clearly to such an extent that one skilled in the art easily carries out the present disclosure.

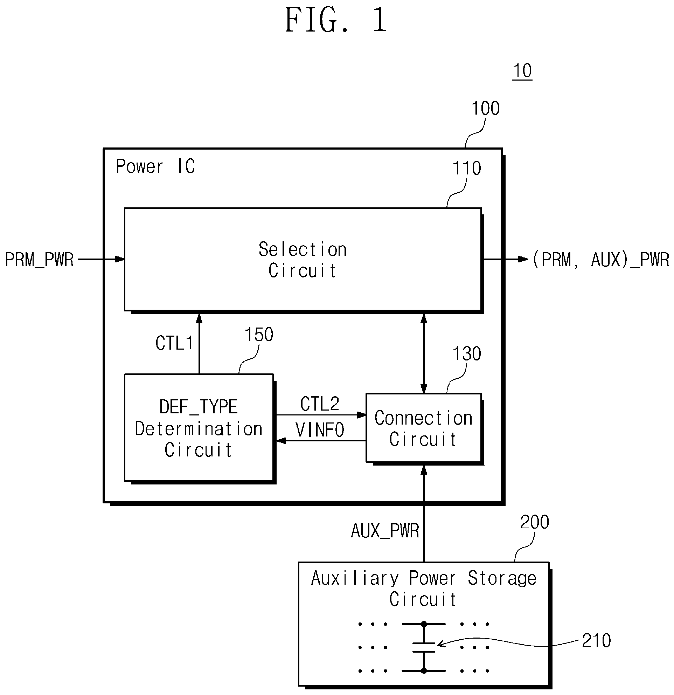

FIG. 1 is a block diagram illustrating a capacitor defect monitoring device according to an embodiment of the present disclosure.

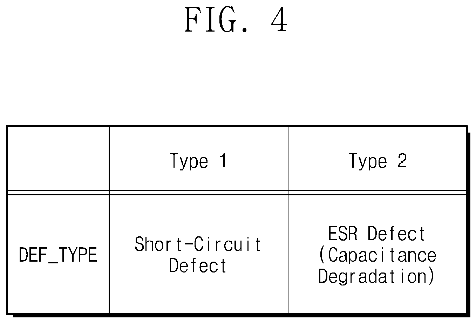

Referring to FIG. 1, a capacitor defect monitoring device 10 may include a power integrated circuit 100 and an auxiliary power storage circuit 200. The auxiliary power storage circuit 200 may include one or more storage capacitors 210. For example, the auxiliary power storage circuit 200 may be used in an electronic device or an electronic system together with the power integrated circuit 100, and the performance of the auxiliary power storage circuit 200 may be reduced over time due to aging, degradation, overvoltage, physical vibration, moisture, etc. The capacitor defect monitoring device 10 may determine a defect type of the auxiliary power storage circuit 200. For example, the determination of the defect type of the auxiliary power storage circuit 200 may mean determining all or some of defect types of the one or more storage capacitors 210 included in the auxiliary power storage circuit 200. The defect type of the auxiliary power storage circuit 200 will be described with reference to FIG. 4.

The power integrated circuit 100 may output one of a primary power PRM _PWR and an auxiliary power AUX_PWR. For example, an external electronic device (e.g., a host device) may provide the primary power PRM_PWR to the power integrated circuit 100, the auxiliary power storage circuit 200 may provide the auxiliary power AUX_PWR to the power integrated circuit 100, and the power integrated circuit 100 may selectively output one of the primary power PRM_PWR and the auxiliary power AUX_PWR.

The power integrated circuit 100 may include a selection circuit 110, a connection circuit 130, and a defect type determination circuit 150.

The selection circuit 110 may select one of the primary power PRM _PWR and the auxiliary power AUX_PWR, and the connection circuit 130 may provide a connection path between the selection circuit 110 (or the power integrated circuit 100) and the auxiliary power storage circuit 200.

In an auxiliary power monitoring mode, based on changing a resistance value of the connection path, the defect type determination circuit 150 may monitor changes in voltage levels of the one or more storage capacitors 210 and may determine the defect type of the auxiliary power storage circuit 200. For example, the auxiliary power monitoring mode may be an operation mode of the capacitor defect monitoring device 10 for determining the defect type of the auxiliary power storage circuit 200.

In an embodiment, the defect type determination circuit 150 may measure changes in voltage levels of two nodes of the connection path and may indirectly monitor the changes in the voltage levels of the one or more storage capacitors 210.

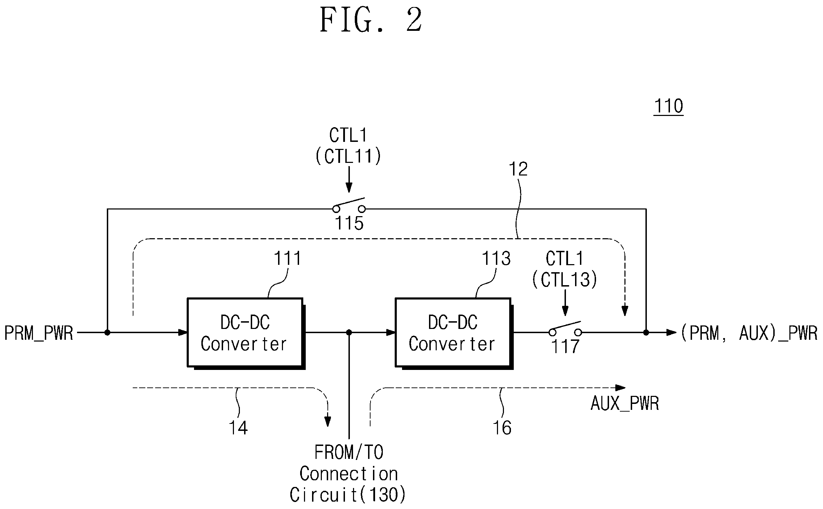

In an embodiment, an operation mode in which the power integrated circuit 100 outputs the primary power PRM_PWR (or the selection circuit 110 selects the primary power PRM_PWR) may be referred to as a primary power output mode. For example, the primary power output mode may be an operation mode corresponding to the case where the primary power PRM_PWR is stably provided from the external electronic device to the power integrated circuit 100. In a same or different embodiment, an operation mode in which the power integrated circuit 100 outputs the auxiliary power AUX_PWR (or the selection circuit 110 selects the auxiliary power AUX_PWR) may be referred to as an auxiliary power output mode. For example, the auxiliary power output mode may be an operation mode corresponding to the case where the supply of the primary power PRM_PWR from the external electronic device is suddenly blocked. For example, when the sudden power-off (SPO) event occurs, the power integrated circuit 100 may output the auxiliary power AUX_PWR provided from the auxiliary power storage circuit 200 and may operate in the auxiliary power output mode. The primary power output mode and the auxiliary power output mode will be described with reference to FIG. 2.

In an embodiment, the auxiliary power monitoring mode may be an operation mode in which the capacitor defect monitoring device 10 detects the defect type of the auxiliary power storage circuit 200 while the power integrated circuit 100 operates in the primary power output mode. For example, because the auxiliary power storage circuit 200 provides the auxiliary power AUX_PWR to the power integrated circuit 100 while the power integrated circuit 100 operates in the auxiliary power output mode, to enter the auxiliary power monitoring mode in the auxiliary power output mode may be blocked.

In an embodiment, the defect type determination circuit 150 may provide the selection circuit 110 with a control signal CTL1 for the primary power output mode or the auxiliary power output mode and may provide the connection circuit 130 with a control signal CTL2 for the auxiliary power monitoring mode, or vice versa

In an embodiment, the connection circuit 130 may change the resistance value of the connection path from the auxiliary power storage circuit 200 to the selection circuit 110 in the auxiliary power monitoring mode. For example, the connection circuit 130 may increase the resistance value of the connection path in the auxiliary power monitoring mode. For example, the connection circuit 130 may include a switch and resistors to increase the resistance value of the connection path, and the control signal CTL2 may be a signal for selecting one of the resistors. For example, as the resistance value of the connection path is changed, voltage levels of the one or more storage capacitors 210 included in the auxiliary power storage circuit 200 may be changed, the connection circuit 130 may provide the defect type determination circuit 150 with voltage information VINFO indicating the changes in the voltage levels. The defect type determination circuit 150 may monitor the changes in the voltage levels of the one or more storage capacitors 210 based on the voltage information VINFO and may determine the defect type of the auxiliary power storage circuit 200. For example, the defect type of the auxiliary power storage circuit 200 may include a short-circuit defect and an equivalent series resistance (ESR) defect. In the short-circuit defect and the ESR defect, the changes in the voltage levels of the one or more storage capacitors 210 may have various forms different from each other. For example, the defect type determination circuit 150 may use reference voltages to determine the defect type of the auxiliary power storage circuit 200. For example, the defect type determination circuit 150 may compare the voltage levels of the one or more storage capacitors 210 with the reference voltages to determine the defect type of the auxiliary power storage circuit 200 and may include one or more processors for the determination of the defect type.

Through the above configuration, a capacitor defect monitoring device according to embodiments of the present disclosure may change a resistance value of a connection path from an auxiliary power storage circuit to a selection circuit (or a power integrated circuit) in an auxiliary power monitoring mode. The capacitor defect monitoring device may also determine a defect type of the auxiliary power storage circuit by monitoring changes in voltage levels of one or more capacitors of the auxiliary power storage circuit based on changing the resistance value of the connection path. The defect type of the auxiliary power storage circuit may include a short-circuit defect and an ESR defect, and the defect types may not be distinguished by a conventional capacitor health monitoring method associated with the auxiliary power storage circuit. The capacitor defect monitoring device may efficiently distinguish the short-circuit defect and the ESR defect of the auxiliary power storage circuit based on changing the resistance value of the connection path and may be applied to a plurality of electronic devices or electronic systems such that the defect type of the auxiliary power storage circuit of each electronic device or each electronic system is efficiently monitored. This may be performed even in real time or remotely.

FIG. 2 is a block diagram illustrating an embodiment of a selection circuit of FIG. 1.

Referring to FIGS. 1 and 2, the selection circuit 110 may include DC-DC converters 111 and 113 for increasing (or boosting/stepping up) or decreasing (or stepping down) the corresponding voltages and switches 115 and 117 for controlling internal paths of the selection circuit 110.

The selection circuit 110 may receive the control signal CTL1 from the defect type determination circuit 150, and the control signal CTL1 may include a control signal CTL11 for controlling the switch 115 and a control signal CTL13 for controlling the switch 117.

Based on the control signal CTL1, the selection circuit 110 may select the primary power PRM_PWR by turning on the switch 115 and turning off the switch 117 in the primary power output mode and may select the auxiliary power AUX_PWR by turning off the switch 115 and turning on the switch 117 in the auxiliary power output mode.

In an embodiment, in the primary power output mode, the primary power PRM_PWR may be transferred to the auxiliary power storage circuit 200 through the DC-DC converter 111 and the connection circuit 130, and thus, the capacitors of the auxiliary power storage circuit 200 may be charged or discharged. In the same or other embodiments, the selection circuit 110 may further include additional switches to charge or discharge the capacitors of the auxiliary power storage circuit 200.

In an embodiment, a path 12 of the selection circuit 110 may indicate a path through which the primary power PRM_PWR is output to the outside in the primary power output mode, and a path 14 of the selection circuit 110 may indicate a path through which the primary power PRM_PWR boosted or stepped down in the primary power output mode is transferred to the auxiliary power storage circuit 200 through the connection circuit 130. A path 16 of the selection circuit 110 may indicate a path through which the auxiliary power AUX_PWR is output to the outside in the auxiliary power output mode.

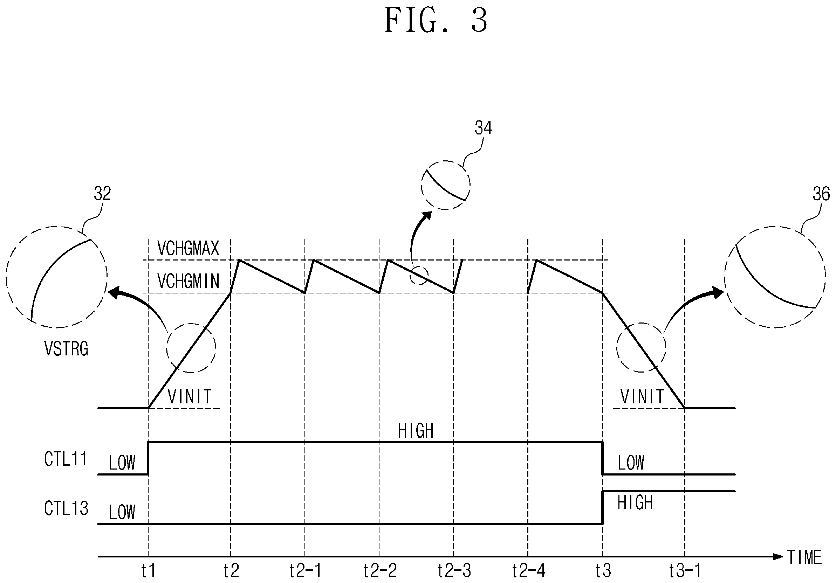

FIG. 3 is a diagram illustrating voltage levels of capacitors of an auxiliary power storage circuit when the auxiliary power storage circuit is charged or discharged.

When the auxiliary power storage circuit 200 is charged or discharged, changes in voltage levels of the capacitors of the auxiliary power storage circuit 200 at time points t1, t2, t2-1, t2-2, t2-3, t2-4, t3, and t3-1 are illustrated in FIG. 3. For example, the changes in the voltage levels of the capacitors illustrated in FIG. 3 are changes in voltage levels of the capacitors in a first case, not a second case where the capacitor defect monitoring device 10 operates in the auxiliary power monitoring mode described with reference to FIG. 1. In the first case, the resistance value of the connection path according to embodiments of the present disclosure is not changed. For example, a time period from t1 to t2 may be referred to as a "charging period", a time period from t2 to t3 may be referred to as a "normal operation period", and a time period from t3 to t3-1 may be referred to as a "discharging period".

Referring to FIGS. 1 and 3, in the charging period, the capacitors of the auxiliary power storage circuit 200 may be charged, and voltage levels of the capacitors of the auxiliary power storage circuit 200 may increase from an initial voltage VINT to a minimum charging voltage VCHGMIN. In the normal operation period, the capacitors of the auxiliary power storage circuit 200 may be repeatedly charged or discharged, and in this case, the voltage levels of the capacitors of the auxiliary power storage circuit 200 may repeatedly increase or decrease between a maximum charging voltage VCHGMAX and the minimum charging voltage VCHGMIN. In the discharging period, the capacitors of the auxiliary power storage circuit 200 may be discharged, and the voltage levels of the capacitors of the auxiliary power storage circuit 200 may decrease from the minimum charging voltage VCHGMIN to the initial voltage VINT.

In an embodiment, before the time point t1, each of the control signals CTL11 and CTL13 may have a logic low level. At the time point t1, the control signal CTL11 may transition from the logic low level to a logic high level. From the time point t1 to the time point t3, the control signal CTL11 may maintain the logic high level, and the control signal CTL13 may maintain the logic low level. At the time point t3, the control signal CTL11 may transition from the logic high level to the logic low level, and the control signal CTL13 may transition from the logic low level to the logic high level.

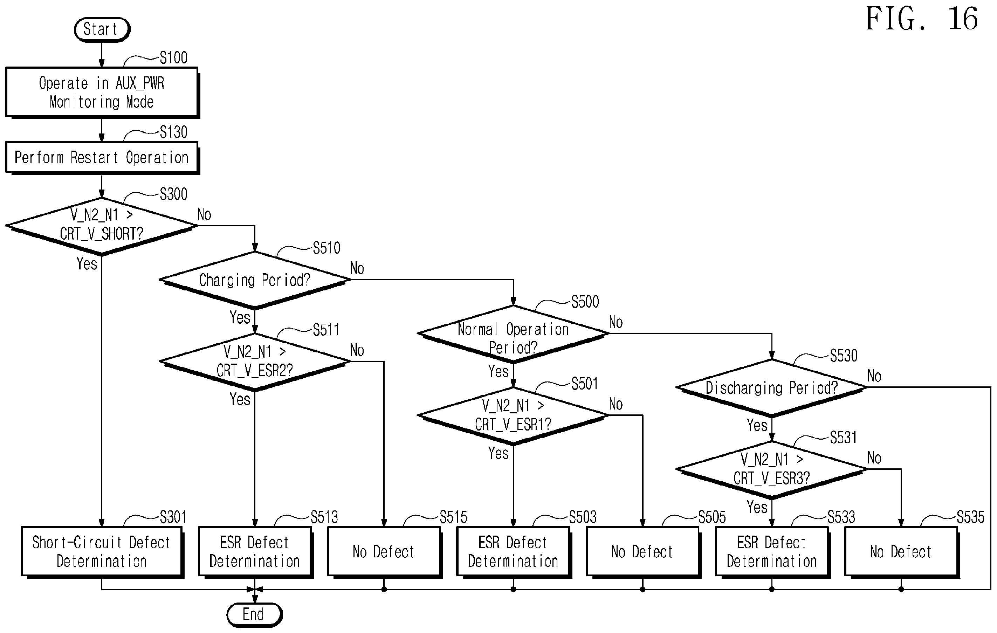

The charging period, the normal operation period, and the discharging period illustrated in FIG. 3 may progress when the capacitor defect monitoring device 10 is powered on at the time point t1 and the power integrated circuit 100 operates in the primary power output mode from the time point t1 and operates in the auxiliary power output mode from the time point t3, but this is provided as an example. As will be described with reference to FIG. 16, the charging period, the normal operation period, and the discharging period may progress forcibly when the capacitor defect monitoring device 10 performs a "restart operation".

Actual voltage levels of the capacitors of the auxiliary power storage circuit 200 in the charging period, the normal operation period, and the discharging period may have forms 32, 34, and 36 illustrated in FIG. 3 depending on an RC time constant.

FIG. 4 is a diagram for describing a defect type of an auxiliary power storage circuit according to an embodiment of the present disclosure.

Referring to FIGS. 1 and 4, a defect type DEF_TYPE of the auxiliary power storage circuit 200 may include the short-circuit defect being a first type and the ESR defect being a second type.

For example, the capacitors may include various types of capacitors such as a ceramic capacitor, an electrolytic capacitor, a tantalum capacitor, a film capacitor, and a super capacitor. Capacitors may be selected depending on a used voltage range, a capacity range, a temperature characteristic, a frequency characteristic, and a price of the capacitors, so as to match a characteristic and a purpose of an electronic product.

The performance of the capacitors may be reduced over time due to aging, degradation, overvoltage, physical vibration, moisture, etc.

In the case of a ceramic capacitor (e.g., a multi-layer ceramic capacitor (MLCC)), a tantalum capacitor, etc., an insulator may be broken down by overvoltage, degradation, moisture, etc., or an internal electrode may be broken down by physical vibration, resulting in the short-circuit defect. In the case of an electrolytic capacitor (e.g., an aluminum capacitor) or a super capacitor (e.g., an electric double layer capacitor (EDLC)), etc., the internal electrode may be broken down by aging, or the internal resistance may increase due to degradation, resulting in the ESR defect. For example, in the case of the short-circuit defect, the capacitance of the capacitor may be maintained, but the leakage current of the capacitor may increase. In the case of the ESR defect, the leakage current of the capacitor may be maintained, but the capacitance of the capacitor may decrease.

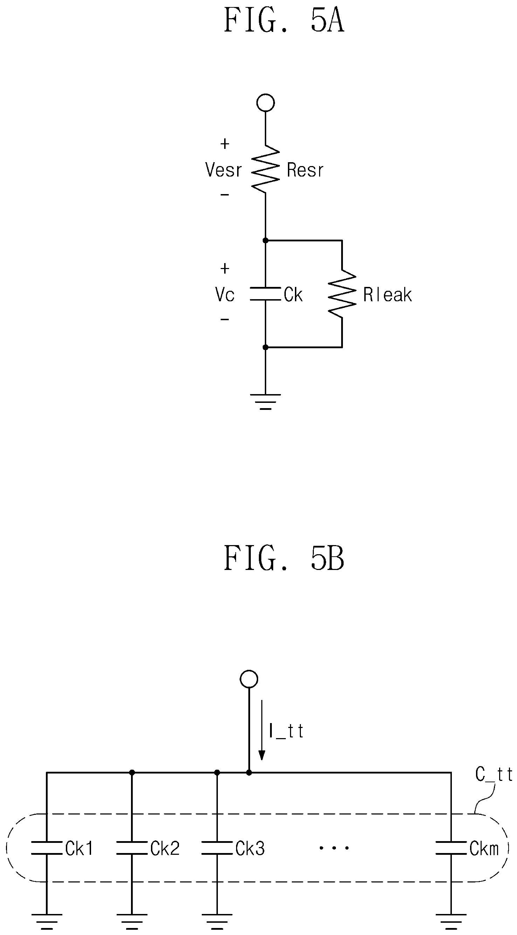

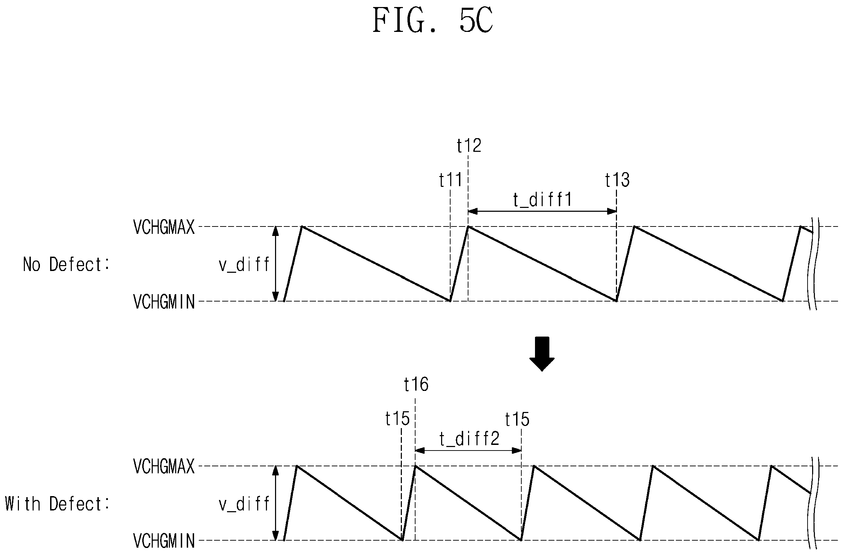

FIGS. 5A, 5B, and 5C are diagrams for describing a short-circuit defect and an equivalent series resistance (ESR) defect according to an embodiment of the present disclosure.

Referring to FIG. 5A, a capacitor having a capacitance Ck may be modeled together with a resistor Rleak associated with the short-circuit defect and a resistor Resr associated with the ESR defect.

For example, as illustrated in FIG. 5A, the resistor Resr may be modeled to be connected in series with the capacitor to reflect a change in an alternating current (AC) response of the capacitor, and the resistor Rleak may be modeled to be connected in parallel with the capacitor to reflect the leakage current.

For example, when a uniform voltage is applied to the capacitor, a voltage Vesr may be applied across the resistor Resr, and a voltage Vc may be applied across the capacitor and the resistor Rleak.

Referring to FIG. 5B, in an auxiliary power storage circuit (e.g., 200 of FIG. 1), capacitors respectively having capacitances Ck1, Ck2, CK3, ..., CKm (m being an integer of 4 or more) may be connected in parallel. For example, a first end of each capacitor may be connected to a ground voltage, and a second end thereof may be connected to one node (e.g., a node of the connection circuit 130 of FIG. 1).

A total capacitance of the capacitor connected in parallel may be a capacitance C_tt, and a current I_tt may flow to all the capacitors when the auxiliary power storage circuit is charged or discharged.

Changes in voltage levels of the capacitors of the auxiliary power storage circuit when the auxiliary power storage circuit including the capacitors of FIG. 5B is charged or discharged are illustrated in FIG. 5C. For example, the changes in the voltage levels of the capacitors illustrated in FIG. 5C may be changes in voltage levels in the normal operation period described with reference to FIG. 3, and a charging/discharging period when there is a defect may decrease compared to the case there is no defect.

For example, when there is no defect, the voltage levels of the capacitors may increase as much as a voltage v_diff during a time period from t11 to t12, and the voltage levels of the capacitors may decrease during a time period from t12 to t13. When a defect exists, the voltage levels of the capacitors may increase as much as the voltage v_diff during a time period from t15 to t16, and the voltage levels of the capacitors may decrease during a time period from t16 to t17. A decrease time period t_diff2 (e.g., from t16 to t17) of the voltage levels of the capacitors when a defect exists may be smaller than a decrease time period t_diff1 (e.g., from t12 to t13) of the voltage levels of the capacitors when there is no defect.

For example, the decrease time period t_diff1 may be calculated by an equation of "C_tt × v_diff / I_tt (= t_diff1)", and decrease time period t_diff2 may be calculated by an equation of "C_tt × v_diff / I_tt (= t_diff2)". C_tt may be the total capacitance of the parallel-connected capacitors described with reference to FIG. 5B, and I_tt may be the current flowing to all the parallel-connected capacitors.

In the conventional capacitor health monitoring method associated with the auxiliary power storage circuit, whether the auxiliary power storage circuit is defective may be detected by monitoring a change in the decrease time periods (e.g., t_diff1 → t_diff2). However, as in the changes illustrated in FIG. 5C, changes may occur in both the short-circuit defect and the ESR defect described with reference to FIG. 4, and in this case, the short-circuit defect and the ESR defect of the auxiliary power storage circuit may not be distinguished by the conventional capacitor health monitoring method.

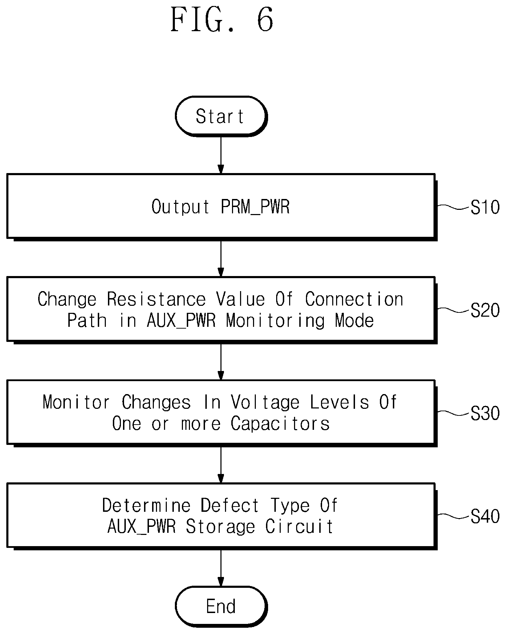

FIG. 6 is a flowchart illustrating a capacitor defect monitoring method according to an embodiment of the present disclosure.

Referring to FIGS. 1 and 6, the primary power PRM_PWR among the primary power PRM_PWR and the auxiliary power AUX_PWR may be output by the power integrated circuit 100 (S10).

In an embodiment, the primary power PRM_PWR may be provided from the outside, and the auxiliary power AUX_PWR may be provided from the auxiliary power storage circuit 200.

In an embodiment, the power integrated circuit 100 may include the selection circuit 110 and the connection circuit 130, the selection circuit 110 may select one of the primary power PRM_PWR and the auxiliary power AUX_PWR, and the connection circuit 130 may provide a connection path between the selection circuit 110 and the auxiliary power storage circuit 200.

In the auxiliary power monitoring mode, a resistance value of the connection path may be changed (S20).

In an embodiment, the auxiliary power monitoring mode may be an operation mode of the capacitor defect monitoring device 10 for determining a defect type of the auxiliary power storage circuit 200.

In an embodiment, the connection circuit 130 may change the resistance value of the connection path from the auxiliary power storage circuit 200 to the selection circuit 110 in the auxiliary power monitoring mode. For example, the connection circuit 130 may increase the resistance value of the connection path in the auxiliary power monitoring mode.

Changes in voltage levels of one or more storage capacitors of the auxiliary power storage circuit 200 may be monitored based on changing the resistance value of the connection path (S30).

In an embodiment, the changes in the voltage levels of the one or more storage capacitors may be indirectly monitored by measuring changes in voltage levels of two nodes of the connection path. The defect type of the auxiliary power storage circuit 200 may be determined based on the monitoring (S40).

For example, the defect type of the auxiliary power storage circuit 200 may include the short-circuit defect and the ESR defect, and in the short-circuit defect and the ESR defect, the changes in the voltage levels of the one or more storage capacitors may have various forms different from each other.

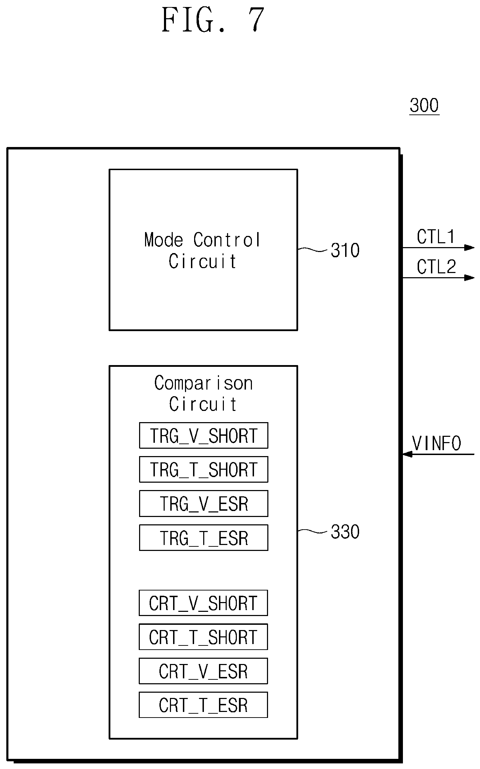

FIG. 7 is a block diagram illustrating a defect type determination circuit according to an embodiment of the present disclosure.

Referring to FIGS. 1 and 7, a defect type determination circuit 300 may correspond to the defect type determination circuit 150. The defect type determination circuit 300 may include a mode control circuit 310 and a comparison circuit 330 and may further include one or more processors.

The mode control circuit 310 may generate the control signals CTL1 and CTL2 and may control the selection circuit 110 and the connection circuit 130 based on the control signals CTL1 and CTL2, respectively. For example, the mode control circuit 310 may output the control signal CTL1 to the selection circuit 110 and may output the control signal CTL2 to the connection circuit 130.

In an embodiment, the mode control circuit 310 may control the power integrated circuit 100 based on the control signal CTL1 such that the power integrated circuit 100 operates in one of the primary power output mode and the auxiliary power output mode described with reference to FIG. 1.

In an embodiment, the mode control circuit 310 may control the capacitor defect monitoring device 10 based on the control signal CTL2 such that the capacitor defect monitoring device 10 operates in the auxiliary power monitoring mode described with reference to FIG. 1.

The comparison circuit 330 may receive the voltage information VINFO from the connection circuit 130 and may monitor changes in voltage levels of one or more storage capacitors of the auxiliary power storage circuit 200 based on the voltage information VINFO. The comparison circuit 330 may in advance store target voltages TRG_V_SHORT and TRG_V_ESR, reference voltages CRT_V_SHORT and CRT_V_ESR, target time points TRG_T_SHORT and TRG_T_ESR, and reference time points CRT_T_SHORT and CRT_T_ESR. To determine the defect type of the auxiliary power storage circuit 200 in the auxiliary power monitoring mode, the comparison circuit 330 may use the target voltages TRG_V_SHORT and TRG_V_ESR, the reference voltages CRT _V_SHORT and CRT_V_ESR, the target time points TRG_T_SHORT and TRG_T_ESR, and the reference time points CRT_T_SHORT and CRT_T_ESR.

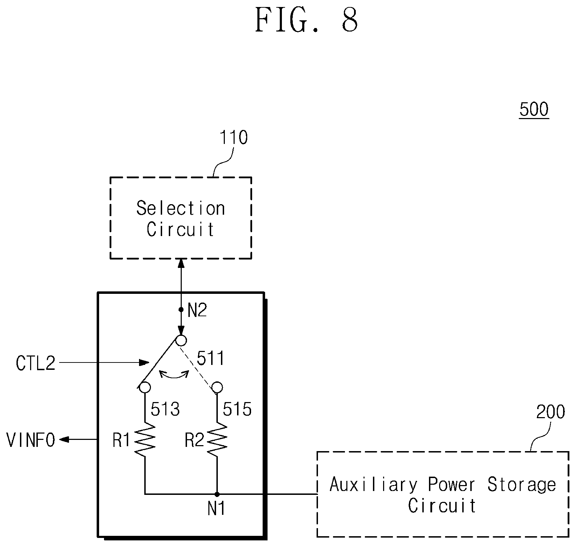

FIG. 8 is a block diagram illustrating a connection circuit according to an embodiment of the present disclosure.

Referring to FIGS. 1 and 8, a connection circuit 500 may correspond to the connection circuit 130. The connection circuit 500 may provide the connection path between the selection circuit 110 (or the power integrated circuit 100) and the auxiliary power storage circuit 200 and may include a first node N1, a second node N2, a switch 511, a first resistor 513, and a second resistor 515.

In an embodiment, the first node N1 may be connected to the auxiliary power storage circuit 200, and the second node N2 may be connected to the selection circuit 110.

In an embodiment, a resistance value of the first resistor 513 may be different from a resistance value of the second resistor 515. For example, the first resistor 513 may have a resistance value R1, and the second resistor 515 may have a resistance value R2. For example, the first resistor 513 may include a resistor of zero ohm, but the scope of the present disclosure is not limited thereto. Even though the first resistor 513 is illustrated in FIG. 8, the connection circuit 500 may not include the first resistor 513. The resistance value R2 of the second resistor 515 may be greater than the resistance value R1 of the first resistor 513.

In an embodiment, the switch 511 may selectively connect one of the first resistor 513 and the second resistor 515 between the first node N1 and the second node N2 based on the control signal CTL2. For example, before entering the auxiliary power monitoring mode, the switch 511 may connect the first resistor 513 between the first node N1 and the second node N2; in the auxiliary power monitoring mode, the switch 511 may connect the second resistor 515 between the first node N1 and the second node N2. For example, when the connection circuit 500 does not include the first resistor 513, before entering the auxiliary power monitoring mode, the switch 511 may directly connect the first node N1 and the second node N2 without a resistance component; in the auxiliary power monitoring mode, the switch 511 may connect the second resistor 515 between the first node N1 and the second node N2.

In an embodiment, the connection circuit 500 may provide the voltage information VINFO to the comparison circuit 330, and the voltage information VINFO may include voltage levels of the first node N1 and the second node N2 and may indicate changes in voltage levels of the one or more storage capacitors 210 included in the auxiliary power storage circuit 200.

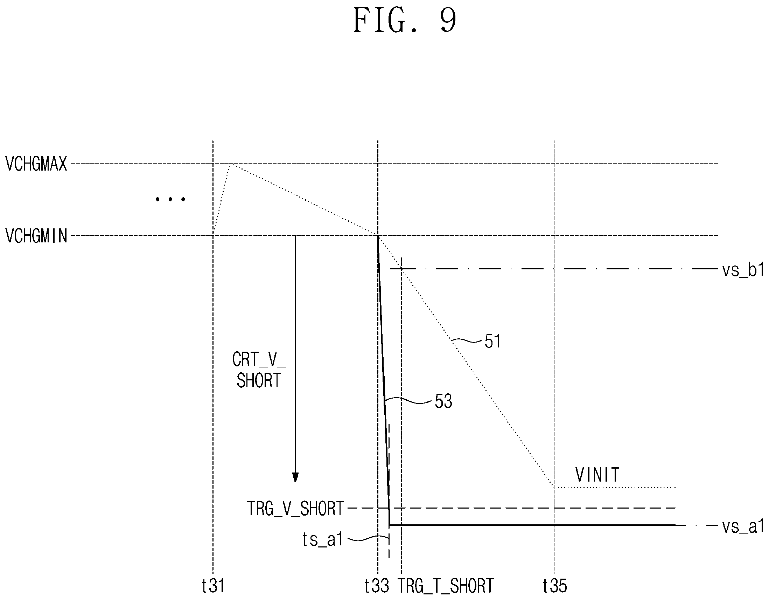

FIG. 9 is a graph indicating a change in a voltage level when a defect type of an auxiliary power storage circuit is a first type according to an embodiment of the present disclosure.

FIG. 9 shows changes in voltage levels of capacitors of an auxiliary power storage circuit (e.g., 200 of FIG. 1) at time points t31, t33, and t35, in the auxiliary power monitoring mode, when a defect type of the auxiliary power storage circuit is the short-circuit defect. As described with reference to FIG. 1, in the auxiliary power monitoring mode, the connection circuit 130 (refer to FIG. 1) may change (or increase) a resistance value of the connection path. For example, the change time point of the resistance value may be t33. The changes in the voltage levels may be changes in the normal operation period or the discharging period described with reference to FIG. 3, but the scope of the present disclosure is not limited thereto.

Referring to FIGS. 1, 4, and 9, at the time point t33, as the entry into the auxiliary power monitoring mode is made, the resistance value of the connection path may be changed; in this case, most of the voltage being applied to the auxiliary power storage circuit 200 through the selection circuit 110 and the connection circuit 130 may be applied across a resistor (e.g., 515 of FIG. 8) of the connection circuit 130, and thus, voltage levels of the capacitors of the auxiliary power storage circuit 200 may sharply decrease immediately after the time point t33.

For example, in FIG. 9, a dotted line 51 may indicate the voltage levels of the capacitors of the auxiliary power storage circuit 200 when the resistance value of the connection path is changed in a state where a defect is absent from the auxiliary power storage circuit 200, and a solid line 53 may indicate the voltage levels of the capacitors of the auxiliary power storage circuit 200 when the resistance value of the connection path is changed in a state where the short-circuit defect is present in the auxiliary power storage circuit 200.

The target short voltage TRG_V_SHORT or the target short time point TRG_T_SHORT may be set to compare a change in voltage levels expressed by the dotted line 51 with a change in voltage levels expressed by the solid line 53. For example, at a time point ts_a1, the solid line 53 may reach the target short voltage TRG_V_SHORT, but the dotted line 51 may does not reach the target short voltage TRG_V_SHORT. For example, at the target short time point TRG_T_SHORT, the solid line 53 may indicate a voltage level vs_a1, and the dotted line 51 may indicate a voltage level vs_b1.

In an embodiment, the reference short voltage CRT_V_SHORT may be set to indicate a magnitude from a specific voltage level (e.g., VCHGMIN) to the target short voltage TRG_V_SHORT. For example, a difference between the voltage levels of the capacitors of the auxiliary power storage circuit 200 or a difference between voltage levels of nodes (e.g., N1 and N2) of a connection circuit (e.g., 500 of FIG. 8) may be compared with the reference short voltage CRT _V_SHORT, but the scope of the present disclosure is not limited thereto. A reference short time point may be further set in a manner similar to the manner of setting the reference short voltage CRT_V_SHORT.

In an embodiment, even though illustrated in FIG. 9, when the capacitors of the auxiliary power storage circuit 200 have the short-circuit defect, the voltage levels of the capacitors before the time point t33 may become lower than the minimum charging voltage VCHGMIN. In this case, the reference short voltage CRT_V_SHORT may be set to be smaller than the magnitude from the specific voltage level (e.g., VCHGMIN) to the target short voltage TRG_V_SHORT.

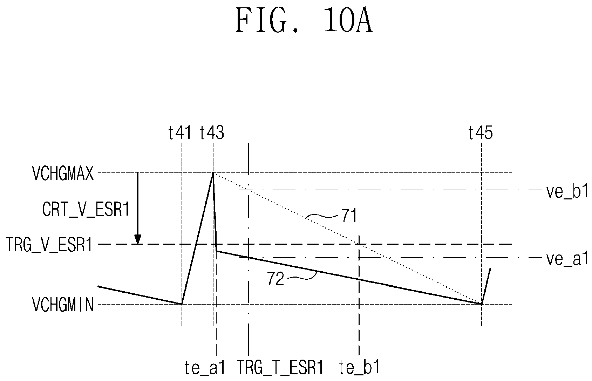

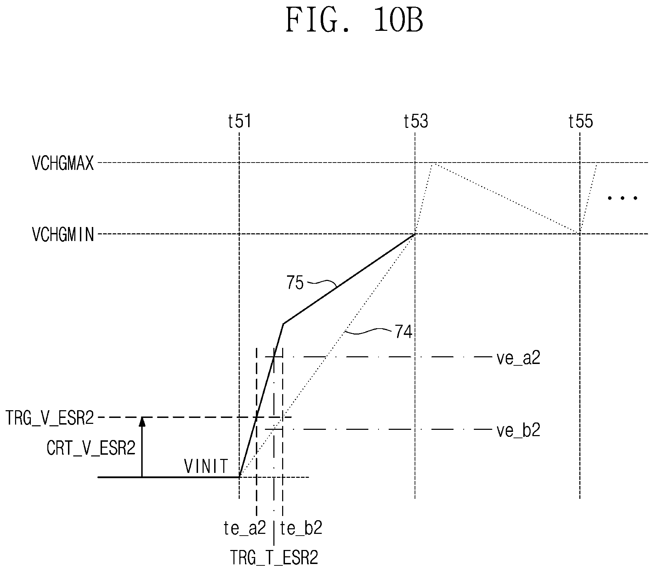

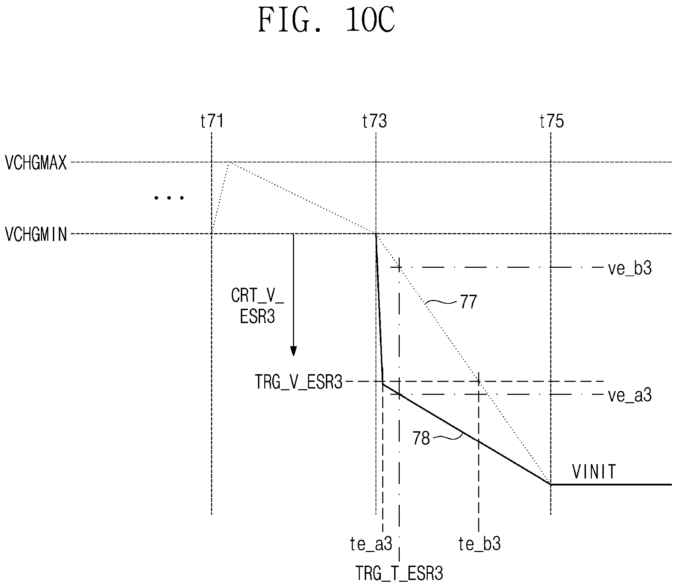

FIGS. 10A, 10B, and 10C are graphs indicating a change in a voltage level when a defect type of an auxiliary power storage circuit is a second type according to an embodiment of the present disclosure.

As illustrated in FIG. 10A, as time points t41, t43, and t45 pass in the normal operation period described with reference to FIG. 3, in the auxiliary power monitoring mode, when a defect type of an auxiliary power storage circuit (e.g., 200 of FIG. 1) is the ESR defect, voltage levels of capacitors of the auxiliary power storage circuit may change. As described with reference to FIG. 1, in the auxiliary power monitoring mode, a connection circuit (e.g., 130 of FIG. 1) may change (or increase) a resistance value of the connection path. For example, the change time point of the resistance value may be t43.

Referring to FIGS. 1, 4, and 10A, at the time point t43, as the entry into the auxiliary power monitoring mode is made, the resistance value of the connection path may be changed; in this case, the voltage being applied to the auxiliary power storage circuit 200 through the selection circuit 110 and the connection circuit 130 may be distributed into a resistor (e.g., 515 of FIG. 8) of the connection circuit 130 and an ESR resistor (e.g., Resr of FIG. 5A), and thus, voltage levels of the capacitors of the auxiliary power storage circuit 200 may sharply decrease immediately after the time point t43.

For example, in FIG. 10A, a dotted line 71 may indicate the voltage levels of the capacitors of the auxiliary power storage circuit 200 when the resistance value of the connection path is changed in a state where a defect is absent from the auxiliary power storage circuit 200, and a solid line 72 may indicate the voltage levels of the capacitors of the auxiliary power storage circuit 200 when the resistance value of the connection path is changed in a state where the short-circuit defect is present in the auxiliary power storage circuit 200. For example, at the solid line 72, a change in the voltage levels of the capacitors of the auxiliary power storage circuit 200 immediately after the time point t43 may decrease more sharply (e.g., faster) as the magnitude of the ESR resistor becomes greater.

A target ESR voltage TRG_V_ESR1 or a target ESR time point TRG_T_ESR1 may be set to compare a change in voltage levels expressed by the dotted line 71 with a change in voltage levels expressed by the solid line 72. For example, the solid line 72 may reach the target ESR voltage TRG_V_ESR1 at a time point te_a1, but the dotted line 71 may reach the target ESR voltage TRG_V_ESR1 at a time point te_b1. For example, at the target ESR time point TRG_T_ESR1, the solid line 72 may indicate a voltage level ve_a1, and the dotted line 71 may indicate a voltage level ve_b1.

In an embodiment, a reference ESR voltage CRT_V_ESR1 may be set to indicate a magnitude from a specific voltage level (e.g., VCHGMAX) to the target ESR voltage TRG_V_ESR1, but the scope of the present disclosure is not limited thereto. For example, a difference between the voltage levels of the capacitors of the auxiliary power storage circuit 200 or a difference between voltage levels of nodes (e.g., N1 and N2) of a connection circuit (e.g., 500 of FIG. 8) may be compared with the reference ESR voltage CRT_V_ESR1, but the scope of the present disclosure is not limited thereto. A reference ESR time point may be further set in a manner similar to the manner of setting the reference ESR voltage CRT_V_ESR1.

As illustrated in FIG. 10B, as the time points t41, t43, and t45 pass in the charging period described with reference to FIG. 3, in the auxiliary power monitoring mode, when a defect type of an auxiliary power storage circuit is the ESR defect, voltage levels of capacitors of the auxiliary power storage circuit may change. In the auxiliary power monitoring mode, a time point at which the resistance value of the connection path is changed may be t51.

Referring to FIGS. 1, 4, and 10B, at the time point t51, as the entry into the auxiliary power monitoring mode is made, the resistance value of the connection path may be changed; in this case, the voltage being applied to the auxiliary power storage circuit 200 through the selection circuit 110 and the connection circuit 130 may be distributed into the resistor of the connection circuit 130 and the ESR resistor, and thus, voltage levels of the capacitors of the auxiliary power storage circuit 200 may smoothly decrease immediately after the time point t51.

For example, in FIG. 10B, a dotted line 74 may indicate the voltage levels of the capacitors of the auxiliary power storage circuit 200 when the resistance value of the connection path is changed in a state where a defect is absent from the auxiliary power storage circuit 200, and a solid line 75 may indicate the voltage levels of the capacitors of the auxiliary power storage circuit 200 when the resistance value of the connection path is changed in a state where the ESR defect is present in the auxiliary power storage circuit 200.

A target ESR voltage TRG_V_ESR2 or a target ESR time point TRG_T_ESR2 may be set to compare a change in voltage levels expressed by the dotted line 74 with a change in voltage levels expressed by the solid line 75. For example, the solid line 75 may reach the target ESR voltage TRG_V_ESR2 at a time point te_a2, but the dotted line 74 may reach the target ESR voltage TRG_V_ESR2 at a time point te_b2. For example, at the target ESR time point TRG_T_ESR2, the solid line 75 may indicate a voltage level ve_a2, and the dotted line 74 may indicate a voltage level ve_b2.

In an embodiment, a reference ESR voltage CRT _V_ESR2 may be set to indicate a magnitude from a specific voltage level (e.g., VINT) to the target ESR voltage TRG_V_ESR2, but the scope of the present disclosure is not limited thereto. For example, a difference between the voltage levels of the capacitors of the auxiliary power storage circuit 200 or a difference between voltage levels of nodes (e.g., N1 and N2) of a connection circuit (e.g., 500 of FIG. 8) may be compared with the reference ESR voltage CRT_V_ESR2, but the scope of the present disclosure is not limited thereto. A reference ESR time point may be further set in a manner similar to the manner of setting the reference ESR voltage CRT_V_ESR2.

As illustrated in FIG. 10C, as time points t71, t73, and t75 pass in the discharging period described with reference to FIG. 3, in the auxiliary power monitoring mode, when a defect type of an auxiliary power storage circuit is the ESR defect, voltage levels of capacitors of the auxiliary power storage circuit may change. In the auxiliary power monitoring mode, a time point at which the resistance value of the connection path is changed may be t73.

Referring to FIGS. 1, 4, and 10C, at the time point t73, as the entry into the auxiliary power monitoring mode is made, the resistance value of the connection path may be changed; in this case, the voltage being applied to the auxiliary power storage circuit 200 through the selection circuit 110 and the connection circuit 130 may be distributed into the resistor of the connection circuit 130 and the ESR resistor, and thus, voltage levels of the capacitors of the auxiliary power storage circuit 200 may sharply decrease immediately after the time point t73.

For example, in FIG. 10C, a dotted line 77 may indicate the voltage levels of the capacitors of the auxiliary power storage circuit 200 when the resistance value of the connection path is changed in a state where a defect is absent from the auxiliary power storage circuit 200, and a solid line 78 may indicate the voltage levels of the capacitors of the auxiliary power storage circuit 200 when the resistance value of the connection path is changed in a state where the ESR defect is present in the auxiliary power storage circuit 200. For example, at the solid line 78, a change in the voltage levels of the capacitors of the auxiliary power storage circuit 200 immediately after the time point t73 may decrease more sharply (e.g., faster) as the magnitude of the ESR resistor becomes greater.

A target ESR voltage TRG_V_ESR3 or a target ESR time point TRG_T_ESR3 may be set to compare a change in voltage levels expressed by the dotted line 77 with a change in voltage levels expressed by the solid line 78. For example, the solid line 78 may reach the target ESR voltage TRG_V_ESR3 at a time point te_a3, but the dotted line 77 may reach the target ESR voltage TRG_V_ESR3 at a time point te_b3. For example, at the target ESR time point TRG_T_ESR3, the solid line 78 may indicate a voltage level ve_a3, and the dotted line 77 may indicate a voltage level ve_b3.

In an embodiment, a reference ESR voltage CRT _V_ESR3 may be set to indicate a magnitude from a specific voltage level (e.g., VCHGMIN) to the target ESR voltage TRG_V_ESR3, but the scope of the present disclosure is not limited thereto. For example, a difference between the voltage levels of the capacitors of the auxiliary power storage circuit 200 or a difference between voltage levels of nodes (e.g., N1 and N2) of a connection circuit (e.g., 500 of FIG. 8) may be compared with the reference ESR voltage CRT_V_ESR3, but the scope of the present disclosure is not limited thereto. A reference ESR time point may be further set in a manner similar to the manner of setting the reference ESR voltage CRT_V_ESR3.

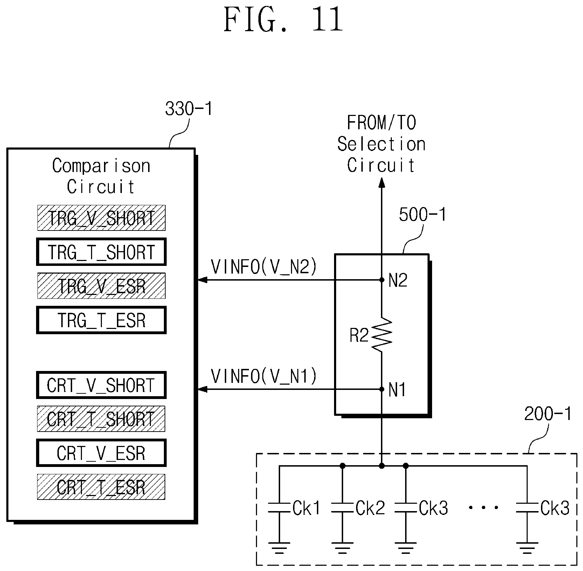

FIG. 11 is a block diagram illustrating a capacitor defect monitoring device according to an embodiment of the present disclosure.

In FIG. 11, a comparison circuit 330-1, a connection circuit 500-1, and an auxiliary power storage circuit 200-1 are illustrated as some components of the capacitor defect monitoring device 10 of FIG. 1 and the defect type determination circuit 300 of FIG. 7. The comparison circuit 330-1, the connection circuit 500-1, and the auxiliary power storage circuit 200-1 may respectively correspond to a comparison circuit (e.g., 330 of FIG. 7), a connection circuit (e.g., 130 of FIG. 1 and 500 of FIG. 8), and an auxiliary power storage circuit (e.g., 200 of FIG. 1).

The comparison circuit 330-1 may in advance store the target time points TRG_T_SHORT and TRG_T_ESR and the reference voltages CRT _V_SHORT and CRT_V_ESR. The target time points TRG_T_SHORT and TRG_T_ESR and the reference voltages CRT_V_SHORT and CRT_V_ESR are described in detail elsewhere in this disclosure.

As described with reference to FIG. 8, in the auxiliary power monitoring mode, the connection circuit 500-1 may connect the second resistor 515 having the resistance value R2 between the first node N1 and the second node N2. The connection circuit 500-1 may provide the comparison circuit 330-1 with the voltage information VINFO including a voltage level V_N1 of the first node N1 and a voltage level V_N2 of the second node N2.

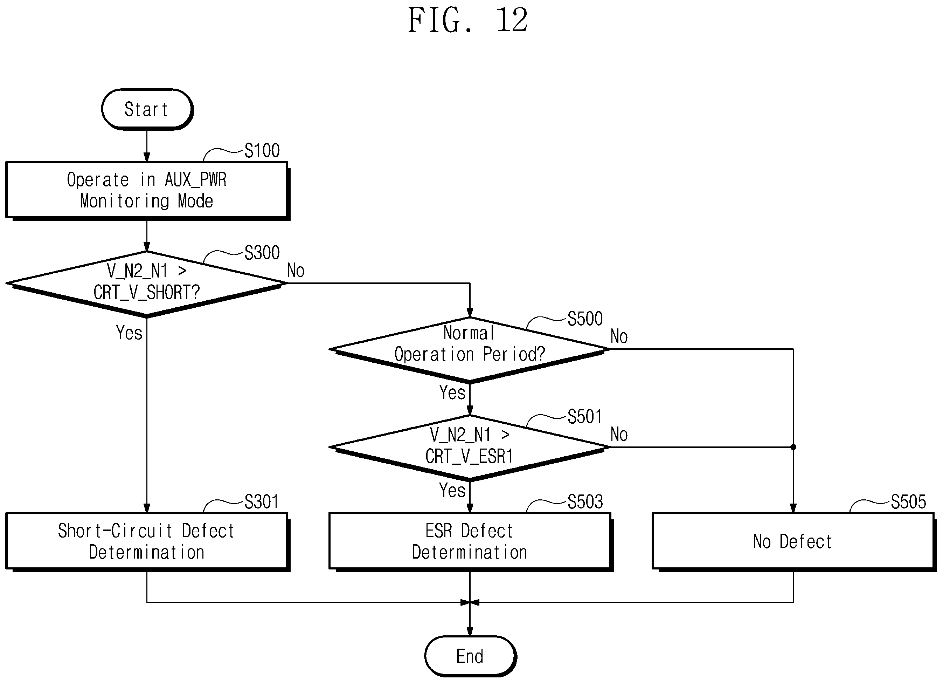

FIG. 12 is a flowchart illustrating an operation of a capacitor defect monitoring device according to an embodiment of the present disclosure.

Referring to FIGS. 11 and 12, a capacitor defect monitoring device may operate in the auxiliary power monitoring mode (S100). For example, in the auxiliary power monitoring mode, a defect type determination circuit may increase a resistance value of a connection path of the connection circuit 500-1. For example, the connection circuit 500-1 may include a resistor having the increased resistance value.

In an embodiment, in the auxiliary power monitoring mode, the defect type determination circuit may determine a defect type of an auxiliary power storage circuit based on a reference voltage and voltage levels of opposite ends of the resistor having the increased resistance value. For example, the reference voltage may include the reference short voltage CRT_V_SHORT described with reference to FIG. 9 and the reference ESR voltage CRT_V_ESR1 described with reference to FIG. 10A. For example, a difference between the voltage levels of the opposite ends of the resistor may correspond to a magnitude by which the voltage levels of the capacitors decrease from the minimum charging voltage VCHGMIN in the graph illustrated in FIG. 9 or a magnitude by which the voltage levels of the capacitors decrease from the maximum charging voltage VCHGMAX in the graph illustrated in FIG. 10A.

Whether a first voltage difference V_N2_N1 being the difference between the voltage levels of the opposite ends of the resistor is greater than the reference short voltage CRT_V_SHORT may be determined (S300).

In response to determining that the first voltage difference V_N2_N1 is greater than the reference short voltage CRT _V_SHORT (Yes in operation S300), the defect type of the auxiliary power storage circuit 200-1 may be determined as corresponding to the first type (e.g., the short-circuit defect).

In response to determining that the first voltage difference V_N2_N1 is smaller than or equal to the reference short voltage CRT_V_SHORT (No in operation S300), whether the capacitor defect monitoring device (or the power integrated circuit) operates in the normal operation period may be determined (S500). In response to determining that the capacitor defect monitoring device operates in the normal operation period, the defect type determination circuit may determine whether the first voltage difference V_N2_N1 is greater than the reference ESR voltage CRT_V_ESR1 (S501).

In an embodiment, in operation S501, the defect type determination circuit may measure the first voltage difference V_N2_N1 immediately after increasing the resistance value of the connection path according to operation S100, may again measure the first voltage difference V_N2 _N1 after a given time passes, and may determine whether a change in the first voltage difference V_N2 _N1 is greater than the reference ESR voltage CRT_V_ESR1 based on the measured results, but the scope of the present disclosure is not limited thereto.

In response to determining that the first voltage difference V_N2_N1 is greater than the reference ESR voltage CRT_V_ESR1 (Yes in operation S501), the defect type of the auxiliary power storage circuit 200-1 may be determined as corresponding to the second type (e.g., the ESR defect).

In response to determining that the capacitor defect monitoring device does not operate in the normal operation period (No in operation S500) or in response to determining that the first voltage difference V_N2 _N1 is smaller than or equal to the reference ESR voltage CRT_V_ESR1 (No in operation S501), the defect type determination circuit may determine that a defect is absent from the auxiliary power storage circuit 200-1.

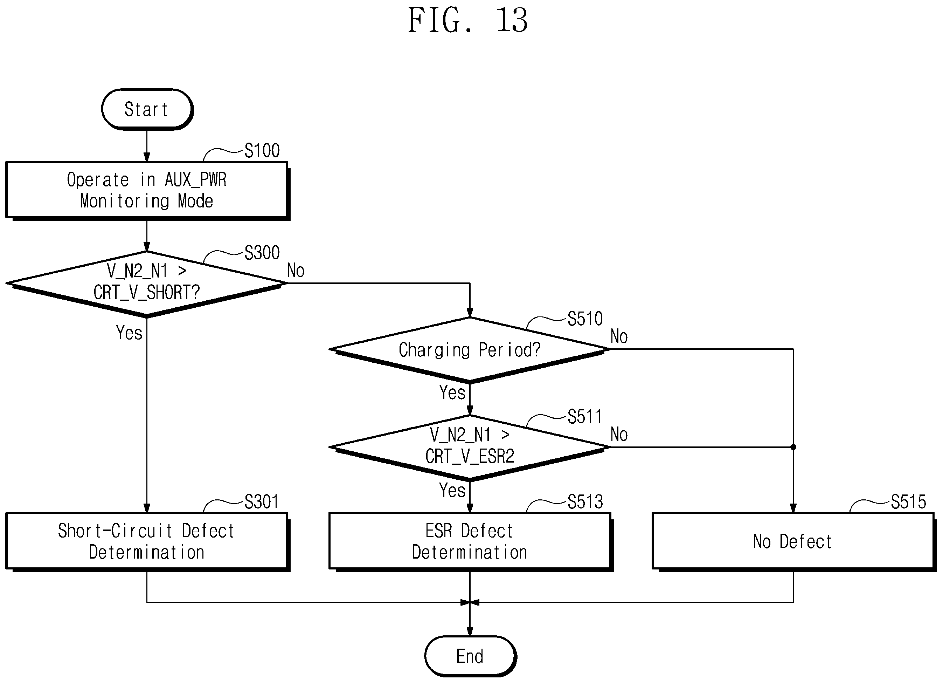

FIG. 13 is a flowchart illustrating an operation of a capacitor defect monitoring device according to an embodiment of the present disclosure.

Referring to FIGS. 11 to 13, in the same or different embodiment, the reference ESR voltage CRT_V_ESR2 may be used instead of the reference ESR voltage CRT_V_ESR1. In other words, in contrast to the embodiment of FIG. 12, in embodiment of this disclosure, the capacitor defect monitoring device may determine the ESR defect in the charging period, not the normal operation period.

The capacitor defect monitoring device may operate in the auxiliary power monitoring mode (S100).

In an embodiment, in the auxiliary power monitoring mode, the defect type determination circuit may determine a defect type of an auxiliary power storage circuit based on a reference voltage and voltage levels of opposite ends of the resistor having the increased resistance value. For example, the reference voltage may include the reference short voltage CRT_V_SHORT described with reference to FIG. 9 and the reference ESR voltage CRT_V_ESR2 described with reference to FIG. 10B. For example, a difference between the voltage levels of the opposite ends of the resistor may correspond to a magnitude by which the voltage levels of the capacitors decrease from the minimum charging voltage VCHGMIN in the graph illustrated in FIG. 9 or a magnitude by which the voltage levels of the capacitors decrease from the initial voltage VINT in the graph illustrated in FIG. 10B.

Whether the first voltage difference V_N2 _N1 being the difference between the voltage levels of the opposite ends of the resistor is greater than the reference short voltage CRT_V_SHORT may be determined (S300).

In response to determining that the first voltage difference V_N2_N1 is greater than the reference short voltage CRT _V_SHORT (Yes in operation S300), the defect type of the auxiliary power storage circuit 200-1 may be determined as corresponding to the first type (e.g., the short-circuit defect).

In response to determining that the first voltage difference V_N2_N1 is smaller than or equal to the reference short voltage CRT _V_SHORT (No in operation S300), whether the capacitor defect monitoring device (or the power integrated circuit) operates in the charging period may be determined (S510).

In response to determining that the capacitor defect monitoring device operates in the charging period, the defect type determination circuit may determine whether the first voltage difference V_N2_N1 is greater than the reference ESR voltage CRT_V_ESR2 (S511).

In an embodiment, in operation S511, the defect type determination circuit may measure the first voltage difference V_N2 _N1 immediately after increasing the resistance value of the connection path according to operation S100, may again measure the first voltage difference V_N2 _N1 after a given time passes, and may determine whether a change in the first voltage difference V_N2 _N1 is greater than the reference ESR voltage CRT _V_ESR2 based on the measured results, but the scope of the present disclosure is not limited thereto.

In response to determining that the first voltage difference V_N2_N1 is greater than the reference ESR voltage CRT_V_ESR2 (Yes in operation S511), the defect type of the auxiliary power storage circuit 200-1 may be determined as corresponding to the second type (e.g., the ESR defect).

In response to determining that the capacitor defect monitoring device does not operate in the charging period (No in operation S510) or in response to determining that the first voltage difference V_N2 _N1 is smaller than or equal to the reference ESR voltage CRT_V_ESR2 (No in operation S511), the defect type determination circuit may determine that a defect is absent from the auxiliary power storage circuit 200-1 (S515).

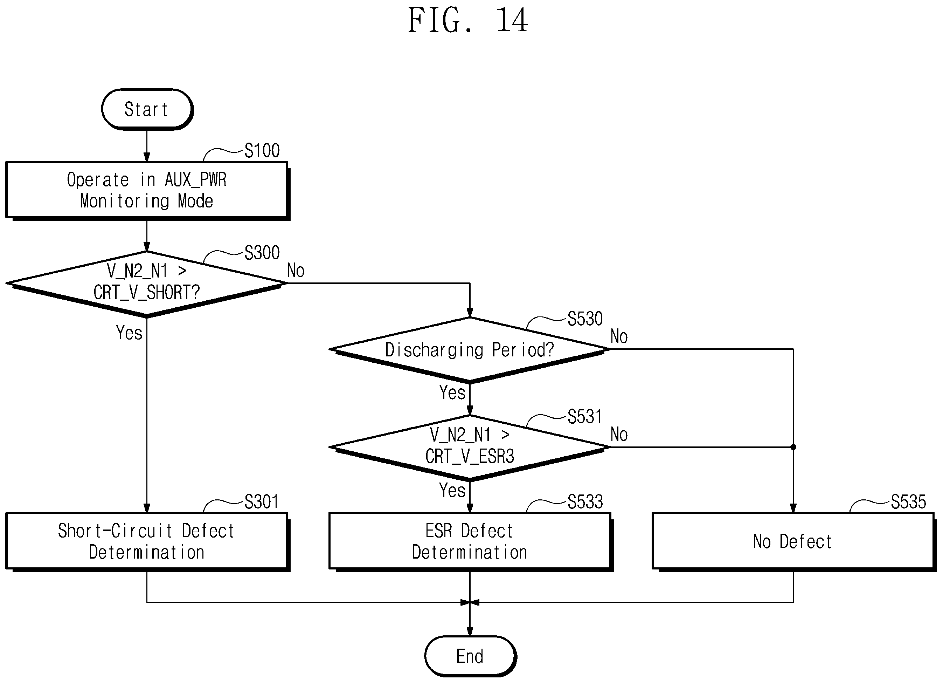

FIG. 14 is a flowchart illustrating an operation of a capacitor defect monitoring device according to an embodiment of the present disclosure.

Referring to FIGS. 11 to 14, the reference ESR voltage CRT_V_ESR3 may be used instead of the reference ESR voltages CRT_V_ESR1 and CRT_V_ESR2. In other words, in contrast to the embodiments of FIG. 12 or 13, the capacitor defect monitoring device may determine the ESR defect in the discharging period, not the normal operation period or the charging period.

The capacitor defect monitoring device may operate in the auxiliary power monitoring mode (S100).

In an embodiment, in the auxiliary power monitoring mode, the defect type determination circuit may determine a defect type of an auxiliary power storage circuit based on a reference voltage and voltage levels of opposite ends of the resistor having the increased resistance value. For example, the reference voltage may include the reference short voltage CRT_V_SHORT described with reference to FIG. 9 and the reference ESR voltage CRT_V_ESR3 described with reference to FIG. 10C. For example, a difference between the voltage levels of the opposite ends of the resistor may correspond to a magnitude by which the voltage levels of the capacitors decrease from the minimum charging voltage VCHGMIN in the graph illustrated in FIG. 9 or a magnitude by which the voltage levels of the capacitors decrease from the minimum charging voltage VCHGMIN in the graph illustrated in FIG. 10C.

Whether the first voltage difference V_N2 _N1 being the difference between the voltage levels of the opposite ends of the resistor is greater than the reference short voltage CRT_V_SHORT may be determined (S300).

In response to determining that the first voltage difference V_N2_N1 is greater than the reference short voltage CRT _V_SHORT (Yes in operation S300), the defect type of the auxiliary power storage circuit 200-1 may be determined as corresponding to the first type (e.g., the short-circuit defect).

In response to determining that the first voltage difference V_N2_N1 is smaller than or equal to the reference short voltage CRT_V_SHORT (No in operation S300), whether the capacitor defect monitoring device (or the power integrated circuit) operates in the discharging period may be determined (S530).

In response to determining that the capacitor defect monitoring device operates in the discharging period, the defect type determination circuit may determine whether the first voltage difference V_N2_N1 is greater than the reference ESR voltage CRT_V_ESR3 (S531).

In an embodiment, in operation S531, the defect type determination circuit may measure the first voltage difference V_N2 _N1 immediately after increasing the resistance value of the connection path according to operation S100, may again measure the first voltage difference V_N2_N1 after a given time passes, and may determine whether a change in the first voltage difference V_N2 _N1 is greater than the reference ESR voltage CRT _V_ESR3 based on the measured results, but the scope of the present disclosure is not limited thereto.

In response to determining that the first voltage difference V_N2_N1 is greater than the reference ESR voltage CRT_V_ESR3 (Yes in operation S531), the defect type of the auxiliary power storage circuit 200-1 may be determined as corresponding to the second type (e.g., the ESR defect).

In response to determining that the capacitor defect monitoring device does not operate in the discharging period (No in operation S530) or in response to determining that the first voltage difference V_N2 _N1 is smaller than or equal to the reference ESR voltage CRT_V_ESR3 (No in operation S531), the defect type determination circuit may determine that a defect is absent from the auxiliary power storage circuit 200-1 (S535).

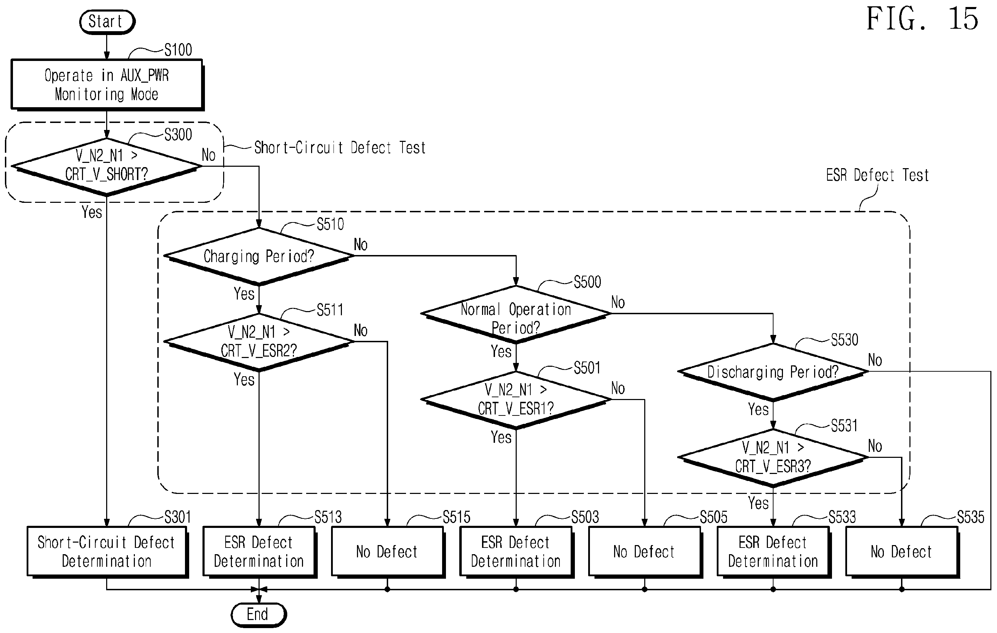

FIG. 15 is a flowchart illustrating an operation of a capacitor defect monitoring device according to an embodiment of the present disclosure.

Referring to FIG. 15, an embodiment of FIG. 15 may include any and all the embodiments of FIGS. 12 to 14. In other words, the capacitor defect monitoring device may operate in one of the normal operation period, the charging period, and the discharging period and may determine the ESR defect.

In an embodiment, operation S100, operation S300, and operation S301 which are illustrated in common in FIGS. 12, 13, and 14 may be performed, and all of operation S500, operation S501, operation S503, and operation S505 illustrated in FIG. 12, operation S510, operation S511, operation S513, and operation S515 illustrated in FIG. 13, and operation S530, operation S531, operation S533, and operation S535 illustrated in FIG. 14 may be performed in the embodiment of FIG. 15.

In an embodiment, operation S300 may be referred to as a "short-circuit defect test", and operation S500, operation S501, operation S510, operation S511, operation S530, and operation S531 may be referred to as an "ESR defect test". For example, in the ESR defect test, when "No" is determined in operation S510 of FIG. 15, operation S500 may be performed, and when "No" is determined in operation S500, operation S530 may be performed. However, a determination order of operation S500, S510, and operation S530 may be variously changed. For example, the ESR defect test may perform only some of operation S500, operation S510, and operation S530.

FIG. 16 is a flowchart illustrating an operation of a capacitor defect monitoring device according to an embodiment of the present disclosure.

Referring to FIG. 16, an embodiment of FIG. 16 may further perform the "restart operation" (S130). For example, the process of FIG. 15 may further include the "restart operation" (S130) of FIG. 16. However, it must be understood that the disclosure is not limited thereto.

In an embodiment, when the capacitor defect monitoring device operates in the normal operation period, the charging period, or the discharging period, as described with reference to FIGS. 12 to 15, the capacitor defect monitoring device may determine the ESR defect. For example, the capacitor defect monitoring device may perform the restart operation such that the charging period, the normal operation period, and the discharging period forcibly progress.

In an embodiment, after the restart operation is performed, the short-circuit defect test and the ESR defect test of FIG. 15 may be performed. In this case, to make the reliability of the ESR defect test better, the capacitor defect monitoring device may test the ESR defect in duplicate by testing the ESR defect in the charging period according to operation S510, then testing the ESR defect in the normal operation period according to operation S500, and then testing the ESR defect in the discharging period according to operation S530.

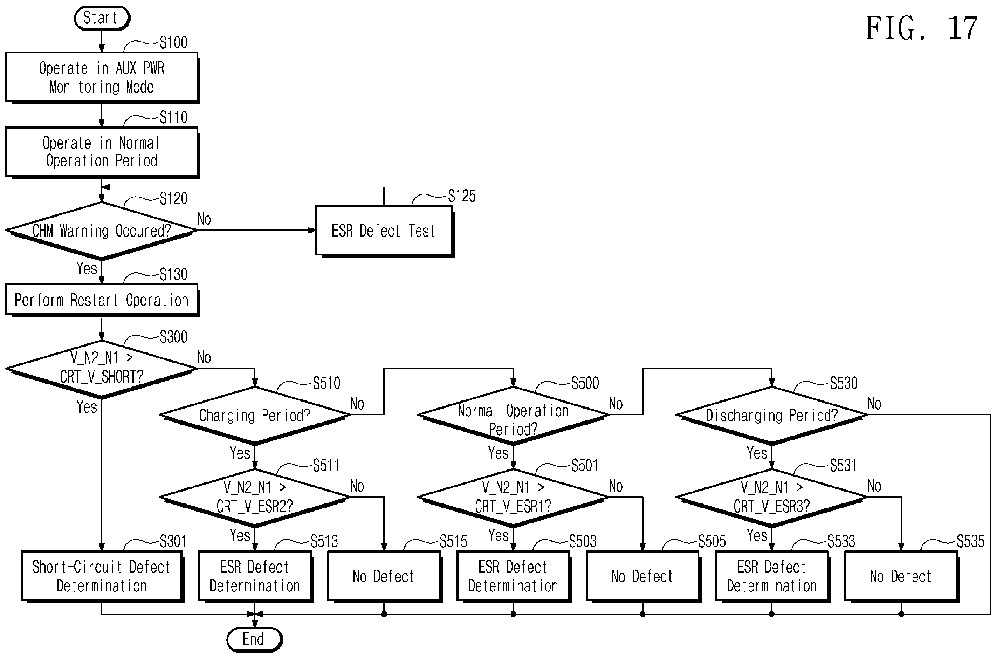

FIG. 17 is a flowchart illustrating an operation of a capacitor defect monitoring device according to an embodiment of the present disclosure.

Referring to FIG. 17, a capacitor defect monitoring device may operate in the normal operation period (S110) and may determine whether a capacitor health monitoring warning occurs (S120).

In response to determining that the capacitor health monitoring warning occurs (Yes in operation S120), the capacitor defect monitoring device may perform the restart operation (S130); In response to determining that the capacitor health monitoring warning does not occur (No in operation S120), the capacitor defect monitoring device may perform the ESR defect test (S125).

FIG. 17 includes operation S110, operation S120, and operation S125. It must be understood that operation S110, operation S120, and operation S125 may be included in one or more other embodiments. For example, FIG. 16 may include operation S110, operation S120, and operation S125.

In an embodiment, operation S110, operation S120, and operation S125 may mean that the capacitor defect monitoring device determines a defect type of capacitors of an auxiliary power storage circuit in real time during an operation of an electronic system including the capacitor defect monitoring device.

In an embodiment, the capacitor health monitoring warning according to operation S120 may be issued when it is determined by the conventional capacitor health monitoring method that a defect is present in the capacitors of the auxiliary power storage circuit. For example, as described with reference to FIG. 5C, the capacitor health monitoring warning may be issued when the charging/discharging period of the auxiliary power storage circuit decreases to a given level or higher, but the scope of the present disclosure is not limited thereto.

In an embodiment, the ESR defect test according to operation S125 may include only operations (e.g., S500 and S501) in which the ESR defect is determined in the normal operation period according to operation S110.

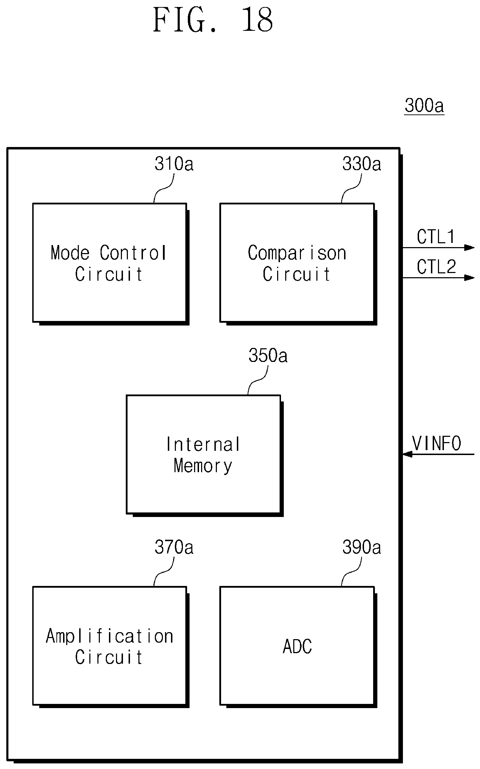

FIG. 18 is a block diagram illustrating a defect type determination circuit according to an embodiment of the present disclosure.

A defect type determination circuit 300a may include an internal memory 350a, an amplification circuit 370a, and an analog-to-digital converter 390a. It must be understood that the defect type determination circuit 300 may further include internal memory, an amplification circuit, and an analog-to-digital converter.

The internal memory 350a may store the target voltages TRG_V_SHORT and TRG_V_ESR, the reference voltages CRT _V_SHORT and CRT_V_ESR, the target time points TRG_T_SHORT and TRG_T_ESR, and the reference time points CRT_T_SHORT and CRT_T_ESR described with reference to FIG. 7.

In an embodiment, the target voltages TRG_V_SHORT and TRG_V_ESR, the reference voltages CRT_V_SHORT and CRT_V_ESR, the target time points TRG_T_SHORT and TRG_T_ESR, and the reference time points CRT_T_SHORT and CRT_T_ESR may be input by an external device before a capacitor defect monitoring device according to embodiments of the present disclosure operates so as to be stored in the internal memory 350a and may be changed or adjusted by the external device, but the scope of the present disclosure is not limited thereto.

When magnitudes of voltage levels included in the voltage information VINFO are smaller than or equal to a given level, the amplification circuit 370a may amplify the magnitudes of the voltage levels.

The analog-to-digital converter 390a may convert a result of the comparison by a comparison circuit 330a into digital signals. The converted digital signals may be transferred to the external host device so as to be collected and managed.

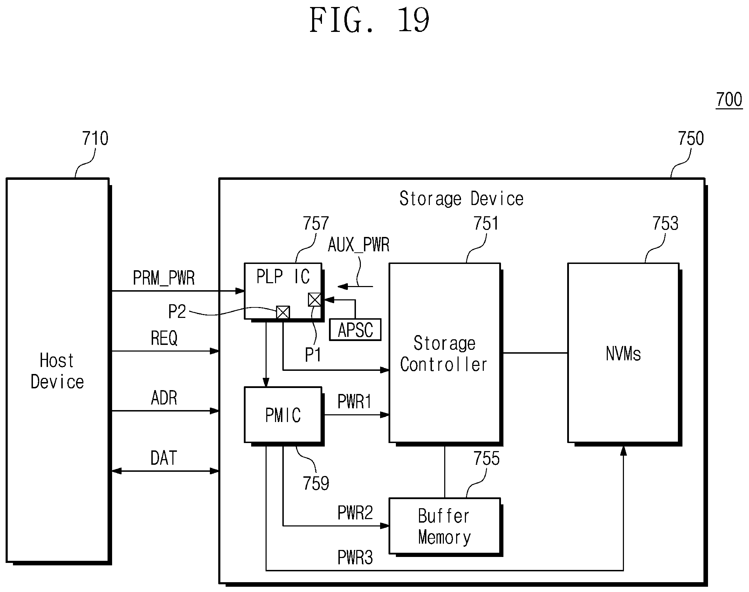

FIG. 19 is a block diagram illustrating an electronic system including a capacitor defect monitoring device according to an embodiment of the present disclosure.

Referring to FIG. 19, an electronic system 700 may include a host device 710 and a storage device 750. The storage device 750 may include a storage controller 751, nonvolatile memories 753, a buffer memory 755, a power loss protection (PLP) integrated circuit (IC) 757, an auxiliary power storage circuit (APSC), and a power management integrated circuit (PMIC) 759.

The host device 710 may transmit a request REQ and an address ADR to the storage device 750 and may exchange data DAT with the storage device 750 based on the request REQ and the address ADR.

The storage controller 751 may overall control the nonvolatile memories 753 and the buffer memory 755. For example, based on the request REQ and the address ADR, the storage controller 751 may program data in the nonvolatile memories 753 or may erase the data stored in the nonvolatile memories 753. For example, the storage controller 751 may temporarily store the data in the buffer memory 755.

The host device 710 may provide the primary power PRM_PWR to the storage device 750, and the storage device 750 may drive the components 751, 753, 755, 757, 778, and 759 of the storage device 750 by using the primary power PRM_PWR.

In an embodiment, the PLP IC 757 and the auxiliary power storage circuit 758 may respectively correspond to the power integrated circuit 100 and the auxiliary power storage circuit 200 described with reference to FIG. 1. For example, the auxiliary power storage circuit 758 may store charges in a primary power output mode and may provide an auxiliary power to external devices based on the stored charges in an auxiliary power output mode. For example, the PLP IC 757 may provide the primary power PRM_PWR to the PMIC 759 in the primary power output mode and may provide the auxiliary power AUX_PWR to the PMIC 759 in the auxiliary power output mode.

In an embodiment, the PMIC 759 may include a plurality of voltage regulators and may generate a plurality of powers PWR1, PWR2, and PWR3 by converting powers provided from the PLP IC 757 by using the voltage regulators. For example, the PMIC 759 may provide the powers PWR1, PWR2, and PWR3 to the storage controller 751, the buffer memory 755, and the nonvolatile memories 753, respectively.

In an embodiment, the PLP IC 757 may additionally include two or more pins P1 and P2 for performing the capacitor defect monitoring method according to embodiments of the present disclosure. For example, the PLP IC 757 may include the pin P1 for the connection with the auxiliary power storage circuit 758 and the pin P2 for the connection with the storage controller 751. For example, a connection circuit (e.g., 130 of FIG. 1 or 500 of FIG. 8) of the PLP IC 757 may be connected to the auxiliary power storage circuit 758 through the pin P1. For example, a defect type determination circuit (e.g., 150 of FIG. 1 or 300 of FIG. 7) of the PLP IC 757 may be connected to the storage controller 751 through the pin P2. For example, a result of the determination by the defect type determination circuit may be transferred to the storage controller 751 through the pin P2.

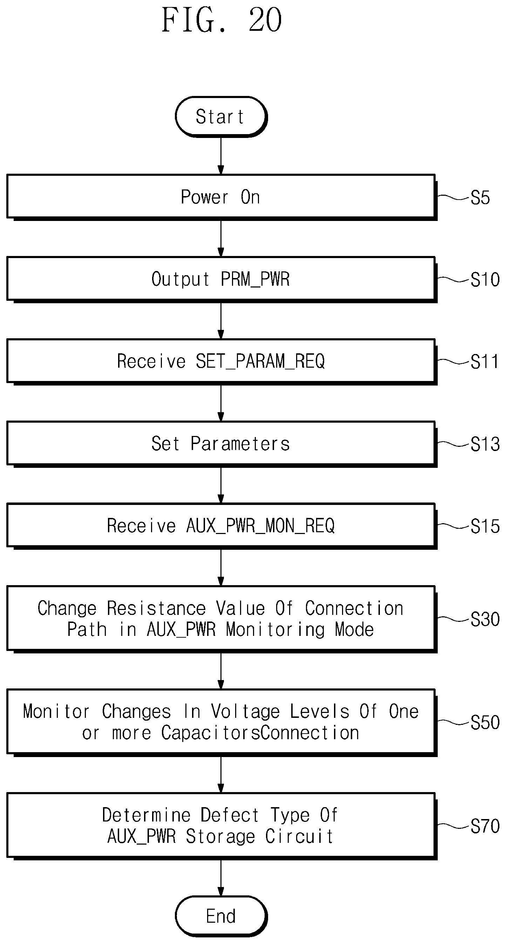

FIG. 20 is a flowchart illustrating an operation of an electronic system according to an embodiment of the present disclosure.

Referring to FIGS. 19 and 20, the electronic system 700 may be powered on (S5).

The primary power PRM_PWR among the primary power PRM_PWR and the auxiliary power AUX_PWR may be output by the PLP IC 757 of the storage device 750 (S10).

The storage device 750 may receive a parameter setting request SET_PARAM_REQ from the host device 710 (S11) and may set parameters based on the parameter setting request SET_PARAM _REQ (S13).

The storage device 750 may receive an auxiliary power monitoring request AUX_PWR_MON_REQ from the host device 710 (S15).

In an auxiliary power monitoring mode, a resistance value of a connection path of a connection circuit may be changed by the PLP IC 757.

Changes in voltage levels of one or more storage capacitors of the auxiliary power storage circuit 200 may be monitored based on changing the resistance value of the connection path (S30).

The defect type of the auxiliary power storage circuit 200 may be determined based on the monitoring (S70).

In the same of different embodiment, the process shown in FIG. 6 may further include operation S5, operation S13, and operation S15. Thus, with respect to FIG. 20, additional description will be omitted to avoid redundancy.

In an embodiment, as described with reference to FIG. 18, the parameter setting request SET_PARAM_REQ may be a request for in advance storing the target voltages TRG_V_SHORT and TRG_V_ESR, the reference voltages CRT _V_SHORT and CRT_V_ESR, the target time points TRG_T_SHORT and TRG_T_ESR, and the reference time points CRT_T_SHORT and CRT_T_ESR in an internal memory of the PLP IC 757 or changing or adjusting the target voltages TRG_V_SHORT and TRG_V_ESR, the reference voltages CRT_V_SHORT and CRT_V_ESR, the target time points TRG_T_SHORT and TRG_T_ESR, and the reference time points CRT_T_SHORT and CRT_T_ESR.

In an embodiment, the auxiliary power monitoring request AUX_PWR_MON_REQ may be a request for entering the auxiliary power monitoring mode described with reference to FIG. 1.

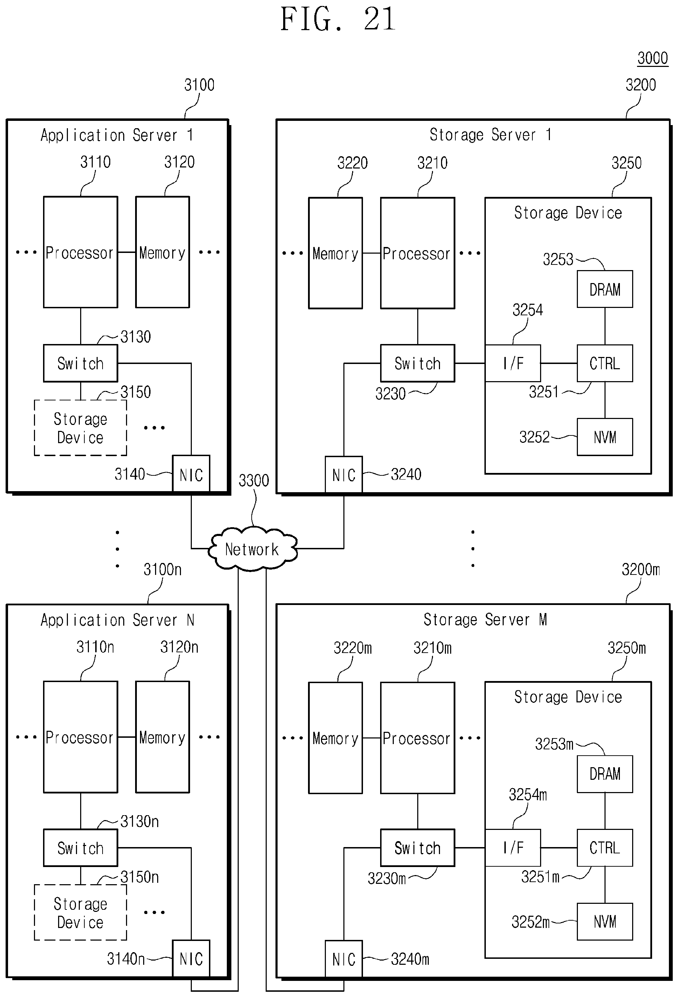

FIG. 21 is a diagram illustrating an electronic device including an electronic device according to an embodiment of the present disclosure.

Referring to FIG. 21, the data center 3000 may be a facility that collects various types of pieces of data and provides services and be referred to as a data storage center. The data center 3000 may be a system for operating a search engine and a database, and may be a computing system used by companies, such as banks, or government agencies. The data center 3000 may include application servers 3100 to 3100n and storage servers 3200 to 3200m. The number of application servers 3100 to 3100n and the number of storage servers 3200 to 3200m may be variously selected according to embodiments. The number of application servers 3100 to 3100n may be different from the number of storage servers 3200 to 3200m.

The application server 3100 or the storage server 3200 may include at least one of processors 3110 and 3210 and memories 3120 and 3220. The storage server 3200 will now be described as an example. The processor 3210 may control all operations of the storage server 3200, access the memory 3220, and execute instructions and/or data loaded in the memory 3220. The memory 3220 may be a double-data-rate synchronous DRAM (DDR SDRAM), a high-bandwidth memory (HBM), a hybrid memory cube (HMC), a dual in-line memory module (DIMM), Optane DIMM, and/or a non-volatile DIMM (NVMDIMM). In some embodiments, the numbers of processors 3210 and memories 3220 included in the storage server 3200 may be variously selected. In an embodiment, the processor 3210 and the memory 3220 may provide a processor-memory pair. In an embodiment, the number of processors 3210 may be different from the number of memories 3220. The processor 3210 may include a single-core processor or a multi-core processor. The above description of the storage server 3200 may be similarly applied to the application server 3100. In some embodiments, the application server 3100 may not include a storage device 3150. The storage server 3200 may include at least one storage device 3250. The number of storage devices 3250 included in the storage server 3200 may be variously selected according to embodiments.

The application servers 3100 to 3100n may communicate with the storage servers 3200 to 3200m through a network 3300. The network 3300 may be implemented by using a fiber channel (FC) or Ethernet. In this case, the FC may be a medium used for relatively high-speed data transmission and use an optical switch with high performance and high availability. The storage servers 3200 to 3200m may be provided as file storages, block storages, or object storages according to an access method of the network 3300.

In an embodiment, the network 3300 may be a storage-dedicated network, such as a storage area network (SAN). For example, the SAN may be an FC-SAN, which uses an FC network and is implemented according to an FC protocol (FCP). As another example, the SAN may be an Internet protocol (IP)-SAN, which uses a transmission control protocol (TCP)/IP network and is implemented according to a SCSI over TCP/IP or Internet SCSI (iSCSI) protocol. In another embodiment, the network 3300 may be a general network, such as a TCP/IP network. For example, the network 3300 may be implemented according to a protocol, such as FC over Ethernet (FCoE), network attached storage (NAS), and NVMe over Fabrics (NVMe-oF).

Hereinafter, the application server 3100 and the storage server 3200 will mainly be described. A description of the application server 3100 may be applied to another application server 3100n, and a description of the storage server 3200 may be applied to another storage server 3200m.

The application server 3100 may store data, which is requested by a user or a client to be stored, in one of the storage servers 3200 to 3200m through the network 3300. Also, the application server 3100 may obtain data, which is requested by the user or the client to be read, from one of the storage servers 3200 to 3200m through the network 3300. For example, the application server 3100 may be implemented as a web server or a database management system (DBMS).

The application server 3100 may access a memory 3120n or a storage device 3150n, which is included in another application server 3100n, through the network 3300. Alternatively, the application server 3100 may access memories 3220 to 3220m or storage devices 3250 to 3250m, which are included in the storage servers 3200 to 3200m, through the network 3300. Thus, the application server 3100 may perform various operations on data stored in application servers 3100 to 3100n and/or the storage servers 3200 to 3200m. For example, the application server 3100 may execute an instruction for moving or copying data between the application servers 3100 to 3100n and/or the storage servers 3200 to 3200m. In this case, the data may be moved from the storage devices 3250 to 3250m of the storage servers 3200 to 3200m to the memories 3120 to 3120n of the application servers 3100 to 3100n directly or through the memories 3220 to 3220m of the storage servers 3200 to 3200m. The data moved through the network 3300 may be data encrypted for security or privacy.

The storage server 3200 will now be described as an example. An interface 3254 may provide physical connection between a processor 3210 and a controller 3251 and a physical connection between a network interface card (NIC) 3240 and the controller 3251. For example, the interface 3254 may be implemented using a direct attached storage (DAS) scheme in which the storage device 3250 is directly connected with a dedicated cable. For example, the interface 3254 may be implemented by using various interface schemes, such as ATA, SATA, e-SATA, an SCSI, SAS, PCI, PCIe, NVMe, IEEE 1394, a USB interface, an SD card interface, an MMC interface, an eMMC interface, a UFS interface, an eUFS interface, and/or a CF card interface.

The storage server 3200 may further include a switch 3230 and the NIC(Network InterConnect) 3240. The switch 3230 may selectively connect the processor 3210 to the storage device 3250 or selectively connect the NIC 3240 to the storage device 3250 via the control of the processor 3210.

In an embodiment, the NIC 3240 may include a network interface card and a network adaptor. The NIC 3240 may be connected to the network 3300 by a wired interface, a wireless interface, a Bluetooth interface, or an optical interface. The NIC 3240 may include an internal memory, a digital signal processor (DSP), and a host bus interface and be connected to the processor 3210 and/or the switch 3230 through the host bus interface. The host bus interface may be implemented as one of the above-described examples of the interface 3254. In an embodiment, the NIC 3240 may be integrated with at least one of the processor 3210, the switch 3230, and the storage device 3250.

In the storage servers 3200 to 3200m or the application servers 3100 to 3100n, a processor may transmit a command to storage devices 3150 to 3150n and 3250 to 3250m or the memories 3120 to 3120n and 3220 to 3220m and program or read data. In this case, the data may be data of which an error is corrected by an ECC engine. The data may be data on which a data bus inversion (DBI) operation or a data masking (DM) operation is performed, and may include cyclic redundancy code (CRC) information. The data may be data encrypted for security or privacy.

Storage devices 3150 to 3150n and 3250 to 3250m may transmit a control signal and a command/address signal to NAND flash memory devices 3252 to 3252m in response to a read command received from the processor. Thus, when data is read from the NAND flash memory devices 3252 to 3252m, a read enable (RE) signal may be input as a data output control signal, and thus, the data may be output to a DQ bus. A data strobe signal DQS may be generated using the RE signal. The command and the address signal may be latched in a page buffer depending on a rising edge or falling edge of a write enable (WE) signal.

The controller 3251 may control all operations of the storage device 3250. In an embodiment, the controller 3251 may include SRAM. The controller 3251 may write data to the NAND flash memory device 3252 in response to a write command or read data from the NAND flash memory device 3252 in response to a read command. For example, the write command and/or the read command may be provided from the processor 3210 of the storage server 3200, the processor 3210m of another storage server 3200m, or the processors 3110 and 3110n of the application servers 3100 and 3100n. DRAM 3253 may temporarily store (or buffer) data to be written to the NAND flash memory device 3252 or data read from the NAND flash memory device 3252. Also, the DRAM 3253 may store metadata. Here, the metadata may be user data or data generated by the controller 3251 to manage the NAND flash memory device 3252. The storage device 3250 may include a secure element (SE) for security or privacy.

For example, the application processor 3100 or the processor 3210 of the storage server 3200 may correspond to the host device 710 of FIG. 19, and the storage device 3250 of the storage server 3200 may correspond to the storage device 750 of FIG. 19. However, the scope of the present disclosure is not limited thereto.

As described above, a capacitor defect monitoring device according to embodiments of the present disclosure may change a resistance value of a connection path from an auxiliary power storage circuit to a selection circuit (or a power integrated circuit) in an auxiliary power monitoring mode and may determine a defect type of the auxiliary power storage circuit by monitoring changes in voltage levels of one or more capacitors of the auxiliary power storage circuit based on changing the resistance value of the connection path. The defect type of the auxiliary power storage circuit may include a short-circuit defect and an ESR defect, and the defect types may not be distinguished by a conventional capacitor health monitoring method associated with the auxiliary power storage circuit. The capacitor defect monitoring device may efficiently distinguish the short-circuit defect and the ESR defect of the auxiliary power storage circuit based on changing the resistance value of the connection path and may be applied to a plurality of electronic devices or electronic systems such that the defect type of the auxiliary power storage circuit of each electronic device or each electronic system is efficiently monitored. This may be performed even in real time or remotely.

While the present disclosure has been described with reference to embodiments thereof, it will be apparent to those of ordinary skill in the art that various changes and modifications may be made thereto without departing from the spirit and scope of the present disclosure as set forth in the following claims.

## Claims

1. A capacitor defect monitoring device comprising:
a power integrated circuit configured to output one of a primary power and an auxiliary power; and
an auxiliary power storage circuit configured to provide the auxiliary power and comprising one or more storage capacitors,
wherein the power integrated circuit comprises:
a selection circuit configured to select one of the primary power and the auxiliary power;
a connection circuit configured to provide a connection path between the selection circuit and the auxiliary power storage circuit; and
a defect type determination circuit configured to monitor changes in voltage values of the one or more storage capacitors to determine a defect type of the auxiliary power storage circuit based on changing a resistance value of the connection path.

2. The capacitor defect monitoring device of claim 1, wherein, based on the power integrated circuit being in an auxiliary power monitoring mode, the defect type determination circuit is further configured to increase the resistance value of the connection path.

3. The capacitor defect monitoring device of claim 2, wherein the connection circuit comprises a resistor having the increased resistance value, and
wherein the defect type determination circuit is further configured to determine the defect type of the auxiliary power storage circuit based on a plurality of reference voltages and voltage levels of opposite ends of the resistor having the increased resistance value.

4. The capacitor defect monitoring device of claim 3, wherein the auxiliary power storage circuit operates in a charging period, a normal operation period, and a discharging period, and
wherein the plurality of reference voltages comprise a reference short voltage, a first reference equivalent series resistance (ESR) voltage, a second reference ESR voltage, and a third reference ESR voltage.

5. The capacitor defect monitoring device of claim 4, wherein, based on a difference between the voltage levels of the opposite ends of the resistor being greater than the reference short voltage, the defect type determination circuit is further configured to determine that the defect type of the auxiliary power storage circuit is a first type.

6. The capacitor defect monitoring device of claim 5, wherein the difference between the voltage levels of the opposite ends of the resistor is a first voltage difference, and
wherein the defect type determination circuit is further configured to determine that the defect type of the auxiliary power storage circuit is a second type based on the first voltage difference being smaller than or equal to the reference short voltage and based on the first voltage difference being greater than the first reference ESR voltage in the normal operation period.

7. The capacitor defect monitoring device of claim 5, wherein the difference between the voltage levels of the opposite ends of the resistor is a first voltage difference, and
wherein the defect type determination circuit is further configured to determine that the defect type of the auxiliary power storage circuit is a second type based on the first voltage difference being smaller than or equal to the reference short voltage and based on the first voltage difference being greater than the second reference ESR voltage in the charging period.

8. The capacitor defect monitoring device of claim 5, wherein the difference between the voltage levels of the opposite ends of the resistor is a first voltage difference, and
wherein the defect type determination circuit is further configured to determine that the defect type of the auxiliary power storage circuit is a second type based on the first voltage difference being smaller than or equal to the reference short voltage and based on the first voltage difference being greater than the third reference ESR voltage in the discharging period.

9. The capacitor defect monitoring device of claim 1, wherein the connection circuit includes:
a first node connected to the auxiliary power storage circuit;
a second node connected to the selection circuit;
a first resistor having a first resistance value and a second resistor having a second resistance value different from the first resistance value; and
a switch configured to selectively connect one of the first resistor and the second resistor between the first node and the second node.

10. The capacitor defect monitoring device of claim 9, wherein the connection circuit is further configured to connect the second resistor between the first node and the second node in an auxiliary power monitoring mode,
wherein the first resistor includes a resistor of zero ohm, and
wherein the resistance value is greater than the first resistance value.

11. The capacitor defect monitoring device of claim 9, wherein the defect type determination circuit is further configured to determine the defect type of the auxiliary power storage circuit based on a plurality of reference voltages and voltage levels of the first node and the second node.

12. The capacitor defect monitoring device of claim 1, wherein, in an auxiliary power monitoring mode and prior to determining the defect type of the auxiliary power storage circuit, the power integrated circuit is further configured to perform a restart operation, the restart operation is configured to cause the auxiliary power storage circuit to sequentially operate in a charging period, a normal operation period, and a discharging period.

13. The capacitor defect monitoring device of claim 12, wherein the power integrated circuit is further configured to perform the restart operation based on a capacitor health monitoring warning occurring and
wherein, prior to the restart operation being performed, the auxiliary power storage circuit operates in the normal operation period.

14. The capacitor defect monitoring device of claim 1, wherein the defect type determination circuit is further configured to determine the defect type of the auxiliary power storage circuit based on a plurality of reference voltages set by an external host device.

15. A method of monitoring capacitor defect, the method comprising:
outputting, by a power integrated circuit, an auxiliary power, wherein the power integrated circuit is configured to output one of a primary power and the auxiliary power, wherein the auxiliary power is provided using an auxiliary power storage circuit, and wherein the primary power is provided from an external source, the power integrated circuit comprising a selection circuit and a connection circuit, the selection circuit selecting one of the primary power and the auxiliary power, and the connection circuit providing a connection path between the selection circuit and the auxiliary power storage circuit;
changing a resistance value of the connection path in an auxiliary power monitoring mode;
monitoring changes in voltage values of one or more storage capacitors of the auxiliary power storage circuit based on changing the resistance value of the connection path; and
determining a defect type of the auxiliary power storage circuit based on the monitoring.

## Amended claims

### Amended claims in accordance with Rule 137(2) EPC.

1. A capacitor defect monitoring device (10) comprising:
a power integrated circuit (100) configured to output one of a primary power (PRM_PWR) and an auxiliary power (AUX_PWR); and
an auxiliary power storage circuit (200) configured to provide the auxiliary power (AUX_PWR) and comprising one or more storage capacitors (210),
wherein the power integrated circuit (100) comprises:
a selection circuit (110) configured to select one of the primary power (PRM_PWR) and the auxiliary power (AUX_PWR);
a connection circuit (130) configured to provide a connection path between the selection circuit (110) and the auxiliary power storage circuit (200); and
a defect type determination circuit (150) configured to monitor changes in voltage values of the one or more storage capacitors (210) to determine a defect type of the auxiliary power storage circuit (200) based on changing a resistance value of the connection path.

2. The capacitor defect monitoring device (10) of claim 1, wherein, based on the power integrated circuit (100) being in an auxiliary power monitoring mode, the defect type determination circuit (150) is further configured to increase the resistance value of the connection path.

3. The capacitor defect monitoring device (10) of claim 2, wherein the connection circuit (130) comprises a resistor (515) having the increased resistance value (R2), and
wherein the defect type determination circuit (150) is further configured to determine the defect type of the auxiliary power storage circuit (200) based on a plurality of reference voltages and voltage levels of opposite ends (N1, N2) of the resistor (515) having the increased resistance value (R2).

4. The capacitor defect monitoring device (10) of claim 3, wherein the auxiliary power storage circuit (200) operates in a charging period, a normal operation period, and a discharging period, and
wherein the plurality of reference voltages comprise a reference short voltage (CRT_V_SHORT), a first reference equivalent series resistance, ESR, voltage (CRT_V_ESR1), a second reference ESR voltage (CRT_V _ESR2), and a third reference ESR voltage (CRT_V_ESR3).

5. The capacitor defect monitoring device (10) of claim 4, wherein, based on a difference (V_N2_N1) between the voltage levels of the opposite ends (N1, N2) of the resistor (515) being greater than the reference short voltage (CRT_V_SHORT), the defect type determination circuit (150) is further configured to determine that the defect type of the auxiliary power storage circuit (200) is a first type.

6. The capacitor defect monitoring device (10) of claim 5, wherein the difference between the voltage levels of the opposite ends (N1, N2) of the resistor (515) is a first voltage difference (V_N2_N1), and
wherein the defect type determination circuit (150) is further configured to determine that the defect type of the auxiliary power storage circuit (200) is a second type based on the first voltage difference (V_N2_N1) being smaller than or equal to the reference short voltage (CRT_V_SHORT) and based on the first voltage difference (V_N2_N1) being greater than the first reference ESR voltage (CRT_V _ESR1) in the normal operation period.

7. The capacitor defect monitoring device (10) of claim 5, wherein the difference between the voltage levels of the opposite ends (N1, N2) of the resistor (515) is a first voltage difference (V_N2_N1), and
wherein the defect type determination circuit (150) is further configured to determine that the defect type of the auxiliary power storage circuit (200) is a second type based on the first voltage difference (V_N2_N1) being smaller than or equal to the reference short voltage (CRT_V_SHORT) and based on the first voltage difference (V_N2_N1) being greater than the second reference ESR voltage CRT_V_ESR2 in the charging period.

8. The capacitor defect monitoring device (10) of claim 5, wherein the difference between the voltage levels of the opposite ends (N1, N2) of the resistor (515) is a first voltage difference (V_N2_N1), and
wherein the defect type determination circuit (150) is further configured to determine that the defect type of the auxiliary power storage circuit (200) is a second type based on the first voltage difference (V_N2_N1) being smaller than or equal to the reference short voltage (CRT_V_SHORT) and based on the first voltage difference (V_N2_N1) being greater than the third reference ESR voltage (CRT_V_ESR3) in the discharging period.

9. The capacitor defect monitoring device (10) of claim 1, wherein the connection circuit (500) includes:
a first node (N1) connected to the auxiliary power storage circuit (200);
a second node (N2) connected to the selection circuit (110);
a first resistor (513) having a first resistance value (R1) and a second resistor (515) having a second resistance value (R2) different from the first resistance value (R1); and
a switch (511) configured to selectively connect one of the first resistor (513) and the second resistor (515) between the first node (N1) and the second node (N2).

10. The capacitor defect monitoring device (10) of claim 9, wherein the connection circuit (500) is further configured to connect the second resistor (515) between the first node (N1) and the second node (N2) in an auxiliary power monitoring mode,
wherein the first resistor (513) includes a resistor of zero ohm, and
wherein the resistance value (R2) is greater than the first resistance value (R1).

11. The capacitor defect monitoring device (10) of claim 9, wherein the defect type determination circuit (150) is further configured to determine the defect type of the auxiliary power storage circuit (200) based on a plurality of reference voltages and voltage levels of the first node (N1) and the second node (N2).

12. The capacitor defect monitoring device (10) of claim 1, wherein, in an auxiliary power monitoring mode and prior to determining the defect type of the auxiliary power storage circuit (200), the power integrated circuit (100) is further configured to perform a restart operation (S130), the restart operation (S130) is configured to cause the auxiliary power storage circuit (200) to sequentially operate in a charging period, a normal operation period, and a discharging period.

13. The capacitor defect monitoring device (10) of claim 12, wherein the power integrated circuit (100) is further configured to perform the restart operation (S130) based on a capacitor health monitoring warning occurring and
wherein, prior to the restart operation (S130) being performed, the auxiliary power storage circuit (200) operates in the normal operation period.

14. The capacitor defect monitoring device (10) of claim 1, wherein the defect type determination circuit (150) is further configured to determine the defect type of the auxiliary power storage circuit (200) based on a plurality of reference voltages set by an external host device (710).

15. A method of monitoring capacitor defect, the method comprising:
Outputting (S10), by a power integrated circuit (100), an auxiliary power (AUX_PWR), wherein the power integrated circuit (100) is configured to output one of a primary power (PRM_PWR) and the auxiliary power (AUX _PWR), wherein the auxiliary power (AUX_PWR) is provided using an auxiliary power storage circuit (200), and wherein the primary power (PRM_PWR) is provided from an external source, the power integrated circuit (100) comprising a selection circuit (110) and a connection circuit (130), the selection circuit (130) selecting one of the primary power (PRM_PWR) and the auxiliary power (AUX _PWR), and the connection circuit (130) providing a connection path between the selection circuit (110) and the auxiliary power storage circuit (200);
changing (S20) a resistance value of the connection path in an auxiliary power monitoring mode;
monitoring (S30) changes in voltage values of one or more storage capacitors (210) of the auxiliary power storage circuit (200) based on changing the resistance value of the connection path; and
determining (S40) a defect type of the auxiliary power storage circuit (200) based on the monitoring.
